(19) Europäisches Patentamt
European Patent Office
Office européen des brevets

(11) **EP 3 848 661 B1**

(12) **EUROPEAN PATENT SPECIFICATION**

(45) Date of publication and mention of the grant of the patent:
**01.11.2023   Bulletin 2023/44**

(21) Application number: **19857318.0**

(22) Date of filing: **11.07.2019**

(51) International Patent Classification (IPC):
**F28D 15/02** *(2006.01)*     **F28D 15/04** *(2006.01)*
**F28D 15/00** *(2006.01)*

(52) Cooperative Patent Classification (CPC):
**F28D 15/0233; F28D 15/046**

(86) International application number:
**PCT/CN2019/095551**

(87) International publication number:
**WO 2020/048223 (12.03.2020 Gazette 2020/11)**

(54) **SLOTTED HEAT PIPE HAVING CIRCUMFERENTIAL SLOTS AND ASSEMBLY METHOD THEREOF**

GESCHLITZTES WÄRMEROHR MIT UMLAUFENDEN SCHLITZEN UND MONTAGEVERFAHREN DAFÜR

CALODUC À FENTES AYANT DES FENTES PÉRIPHÉRIQUES ET SON PROCÉDÉ D'ASSEMBLAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:   **03.09.2018   CN 201811022907**

(43) Date of publication of application:
**14.07.2021   Bulletin 2021/28**

(73) Proprietor: **Beijing Institute of Space Mechanics & Electricity**
**Beijing 100094 (CN)**

(72) Inventors:
• **SHEN, Chunmei**
  **Beijing 100094 (CN)**
• **LUO, Shikui**
  **Beijing 100094 (CN)**
• **YANG, Tao**
  **Beijing 100094 (CN)**
• **LIU, Zhao**
  **Beijing 100094 (CN)**
• **ZHAO, Zhenming**
  **Beijing 100094 (CN)**
• **CUI, Jin**
  **Beijing 100094 (CN)**
• **YU, Feng**
  **Beijing 100094 (CN)**
• **BAI, Jie**
  **Beijing 100094 (CN)**
• **ZHAO, Shilei**
  **Beijing 100094 (CN)**
• **ZHAO, Yu**
  **Beijing 100094 (CN)**
• **SHAO, Heqiang**
  **Beijing 100094 (CN)**
• **GAO, Teng**
  **Beijing 100094 (CN)**
• **YANG, Ming**
  **Beijing 100094 (CN)**
• **WEI, Qiang**
  **Beijing 100094 (CN)**
• **ZHU, Xu**
  **Beijing 100094 (CN)**

(74) Representative: **V.O.**
**P.O. Box 87930**
**2508 DH Den Haag (NL)**

(56) References cited:
CN-A- 101 893 398    CN-A- 101 893 398
CN-A- 103 317 137    CN-A- 106 482 561
CN-A- 106 482 561    CN-A- 107 401 945
CN-A- 109 041 540    CN-A- 109 297 329
CN-U- 201 885 615    US-A1- 2007 012 432
US-A1- 2018 187 979    US-B1- 6 223 812

## Description

### FIELD

The present disclosure relates to a slotted heat pipe with circumferential slots and an assembly method thereof, and belongs to the technical field of heat transfer by means of phase transition.

### BACKGROUND

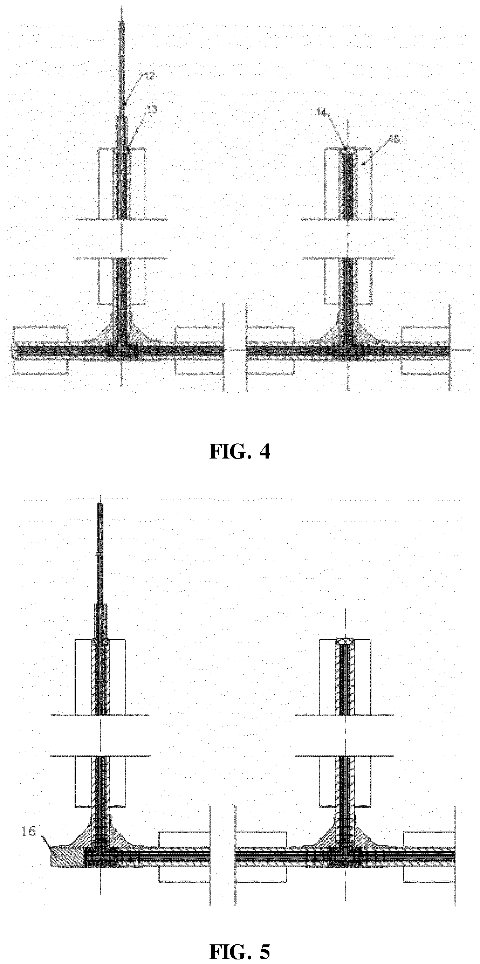

Communication satellite technology plays an important role in various fields in many countries of the world, and a large number of space traveling-wave tubes are the core component of microwave power amplification of a communication satellite. The space traveling-wave tubes of the communication satellite have a large number and high power consumption, and are scattered on a satellite deck, so it is required to take appropriate thermal control measures for the space traveling-wave tubes on the satellite deck to ensure that an in-orbit temperature of the space traveling-wave tubes reaches a required value. At present, the common practice is to arrange the space traveling-wave tubes on an inner side the satellite deck, and an outer surface of the satellite deck is used as a radiation heat-dissipation surface, so as to dissipate the working heat of the space traveling-wave tubes to an outer space. Two sides of the satellite deck are composite-material panels, and the intermediate is a honeycomb core interlayer which has limited thermal conductivity in a surface direction and a thickness direction of the satellite deck. In order to ensure that the heat of the space traveling-wave tubes is well transferred from an inner deck to an outer deck and to avoid the uneven temperature of the deck caused by the uneven heat consumption of the space traveling-wave tubes and the uneven external heat flow on the outer surface of the deck, heat pipes are arranged orthogonally on the satellite deck, to strengthen the heat conduction in the thickness direction of the deck and the temperature equalization in the surface direction. At present, there are three ways of the orthogonal arrangement of heat pipes: full pre-embedded type, full external-pasted type, and hybrid type, as shown in FIG. 4.

The above three arrangements have the following disadvantages:

(1) the full pre-embedded method complicates the manufacturing process of the satellite deck, first equalizer heat pipes are surface-mounted on a lower panel, then a honeycomb core is placed, then parallel heat pipes are placed, and finally an upper panel is placed, which further involves the leveling of the deck; in addition, the heat transfer between the parallel heat pipes and the equalizer heat pipes is realized only through overlap of a small area, the thermal contact resistance is relatively large, and the heat transfer effect is limited;

(2) compared with the full pre-embedded method, the hybrid pre-embedded method has relatively simple manufacturing process for the satellite deck, but a layer of thermal contact resistance with the panel and a thermal conduction resistance of the panel itself are introduced between the equalizer heat pipes and the parallel heat pipes; and

(3) in the full external-pasted type, the horizontal temperature equalization effect of the equalizer heat pipes is realized indirectly through the heat transfer of the overlap between the equalizer heat pipes and the parallel heat pipes, and the temperature equalization effect is not ideal.

It is noted that CN101893398A discloses a profile heat pipe integrated radiator. The radiator comprises a radiating main body. The radiating main body is provided with at least one pipe cavity for storing a working medium, and the radiator also comprises a plurality of sealing components hermetically connected with the pipe cavity. The profile heat pipe integrated radiator is an integrated radiator, and when the heat of a heat source is conducted in the pipe cavity at a high speed, radiating fins radiate a large amount of heat.

It is further noted that CN106482561A discloses a multi-branch heat pipe based on secondary sintering molding and a manufacturing method thereof. The multi-branch heat pipe is of a vacuum closed space structure, and comprises a multi-branch pipe joint, a first branch pipe shell, a second branch pipe shell and an annular sealing plug.

It is further noted that CN201885615U discloses a heat pipe which is arranged on a heating source. The heat pipe comprises a shell body and a capillary structure, wherein the shell body is in closed state, and working fluid is filled in the shell body, while the capillary structure is formed on the inner side wall of the shell body.

It is further noted that CN109041540A discloses a square tube shell cross joint, wherein the main tube shell and the branch tube shell both comprise a plurality of capillary axial grooves, a steam channel and a circumferential groove. The main shell and branch shell are hollow structure, the hollow part is steam channel, the section of steam channel is rectangle with four corners and guide fillet. A capillary axial groove is uniformly distributed on the inner wall surfaces of the main shell and the branch shell, and is located on two opposite parallel wide surfaces of the steam passage and is communicated with the steam passage, and the capillary axial groove is arranged on the inner wall surfaces of the main shell and the branch shell.

It is further noted that US 2018/187979 A1 discloses a heat pipe, which comprises a tube and protrusions. The tube has an internal surface, an external surface, and a length running from a first end to a second end. The protrusions are on the internal surface. A first cross-section of the protrusions at a first location of the length of the tube is different from a second cross-section of the protrusions at a second location of the length of the tube. The tube and the protrusions are monolithic.

## SUMMARY

The present invention provides a slotted heat pipe with circumferential slots according to the appended independent claim 1. The present invention further provides an assembly method of slotted heat pipes with circumferential slots according to the appended independent claim 10. Preferable embodiments of the present invention are provided by the appended dependent claims 2-9 and 11-13.

The technical problem solved by the present disclosure is to overcome the disadvantages of the conventional technology and to provide a slotted heat pipe with circumferential slots and an assembly method thereof. According to the technical solution of the present disclosure, multiple slotted heat pipes with circumferential slots are connected by temperature equalization joints to form an irregular-shaped heat pipe system where internal axial slots and steam passages communicate with each other, to replace an orthogonal-overlap heat pipe system for thermal control of high-power traveling-wave tubes of a communication satellite in the conventional technology, and to solve the problem of low heat transfer efficiency of the existing overlap heat pipe system.

In order to solve the above technical problems, a slotted heat pipe with circumferential slots and an assembly method thereof are provided according to the present disclosure, and a pipe shell of the slotted heat pipe with circumferential slots includes multiple axial slots, circumferential slots, a steam passage and fins. The pipe shell has a hollow circular structure, and the hollow part is the steam passage, the multiple axial slots with small-sized openings are spaced apart in parallel in an inner wall of the pipe shell in a circumferential direction, serving as liquid passages. Liquid and steam conduct heat and mass transfer through steam-liquid interfaces at the openings of the axial slots. The fins are located on an outer circumference of the pipe shell and are configured to fixedly install the pipe shell and increase the heat transfer area of the heat pipe. The multiple circumferential slots are arranged in parallel, a plane where each of the circumferential slots lies is orthogonal to planes where the axial slots lie, and the circumferential slots are in communication with the axial slots.

Multiple slotted heat pipe shells with circumferential slots are connected by temperature equalization joints to form an irregular-shaped heat pipe system where internal axial slots and steam passages communicate with each other.

The temperature equalization joint includes a main pipe shell, a branch pipe shell and a protective shell. The main pipe shell and the branch pipe shell both have a hollow circular structure, and the hollow part is a steam passage, multiple axial slots with small-sized openings are spaced apart in parallel in inner walls of the main pipe shell and the branch pipe shell in a circumferential direction, serving as liquid passages. Liquid and steam conduct heat and mass transfer through steam-liquid interfaces at the openings of the axial slots. The number and size of the axial slots and the size of the steam passages inside the main pipe shell and the branch pipe shell are exactly the same as those of the axial-slotted heat pipe with circumferential slots. Multiple circumferential slots are provided in parallel in the inner walls of the main pipe shell and the branch pipe shell. The plane where each of the circumferential slots lies is orthogonal to the planes where the axial slots in the main pipe shell and the branch pipe shell lie, and each of the circumferential slots is in communication with the axial slots in the main pipe shell and the branch pipe shell.

A V-shaped groove the number of which is the same as that of the branch pipe shell is provided in the middle of the main pipe shell of the temperature equalization joint. The V-shaped groove penetrates though the axial slots and the stream passage, and the tip of the V-shaped groove is located on an axis of the main pipe shell. The branch pipe shell of the temperature equalization joint is provided with a V-shaped protrusion matching the V-shaped groove of the main pipe shell, and the tip of the V-shaped protrusion is located on the axis of the main pipe shell. Both the main pipe shell and the branch pipe shell are placed inside the protective shell of the temperature equalization joint, and the V-shaped protrusion on the branch pipe shell is inserted into the V-shaped groove of the main pipe shell, to ensure that the axial slots inside the main pipe shell are in one-to-one correspondence with the axial slots inside the branch pipe shell at the V-shaped butt portion, and the steam passage of the main pipe shell and the steam passage of the branch pipe shell are communicated with each other. Metal wire meshes are laid inside the main pipe shell and the branch pipe shell, and the metal wire meshes abut against the inner walls of the main pipe shell and the branch pipe shell.

Two ends of the main pipe shell of the temperature equalization joint are respectively butted with two axial-slotted heat pipe shells with circumferential slots. At the butt position, the axial slots of the main pipe shell are in one-to-one correspondence with the axial slots of the axial-slotted heat pipe shells, and the steam passage of the main pipe shell and the steam passages of the axial-slotted heat pipe shells are communicated with each other. One end of the branch pipe shell without the V-shaped protrusion of the temperature equalization joint is butted with one axial-slotted heat pipe shell with circumferential slots. At the butt position, the axial slots of the branch pipe shell are in one-to-one correspondence with the axial slots of the axial-slotted heat pipe shell, and the steam passage of the branch pipe shell and the steam passage of the axial-slotted heat pipe shell are communicated with each other.

The slotted heat pipe shells with circumferential slots may be connected with any two or three of the three connecting ports of the temperature equalization joint, to form an irregular-shaped heat pipe system in a straight shape, an L-shaped cross, a T-shaped cross or a combination of the straight shape, the L-shaped cross, and the T-shaped cross.

When the multiple axial-slotted heat pipe shells with circumferential slots are connected by the multiple temperature equalization joints into the irregular-shaped slotted heat pipe system, the connections of the axial-slotted heat pipe shells and the temperature equalization joints are sealed by welding. In free ends of the axial-slotted heat pipe shells not connected to the temperature equalization joints, at least one free end of the axial-slotted heat pipe shells is welded with a filling end cover. A through hole is provided on the filling end cover. A filling pipe is inserted into the through hole of the filling end cover, and is weld with the filling end cover to form a whole. Other free ends of the axial-slotted heat pipe shells not connected to the temperature equalization joints are welded with sealing end covers. Certain steam-liquid phase-transition heat transfer working medium is filled through the filling pipe, and after the filling, the filling pipe is sealed by cold welding.

If a part of the shell of the irregular-shaped slotted heat pipe system is heated, the liquid working medium in the axial slots at the part absorbs heat and evaporates, and transforms into high-pressure steam to enter the steam passage, and the high-pressure steam enters any other part of the irregular-shaped heat pipe system except the heated part through the steam passages communicated with each other, and condenses into the liquid working medium on an inner wall surface of any other part, and the liquid working medium then flows back to the heated evaporation part along the axial slots communicated with each other by the effect of the capillary suction force generated by the heated evaporation part, and the whole process is cycled on and on, and the heat transfer and temperature equalization of the irregular-shaped heat pipe system are realized through the flow of working medium and the steam-liquid phase transition.

An assembly method of slotted heat pipes with circumferential slots includes the following steps:

step 1: processing axial-slotted heat pipe shells for connection; and processing circumferential slots in the pipe shells, and processing a protective shell, a main pipe shell and a branch pipe shell of a temperature equalization joint;

step 2: processing a sealing end cover, a filling end cover and a filling pipe; and

step 3: assembling the axial-slotted heat pipe shells for connection, the protective shell, the main pipe shell and the branch pipe shell of the temperature equalization joint all processed in the step 1, with the filling pipe, the sealing end cover and the filling end cover all processed in the step 2, to form a slotted heat pipe with circumferential slots, and completing sealing.

The step 1 of processing axial-slotted heat pipe shells for connection and processing circumferential slots in the pipe shells, and processing a protective shell, a main pipe shell and a branch pipe shell of a temperature equalization joint specifically includes the following steps:

step (1.1) processing the axial-slotted heat pipe shells for connection; turning off fins by a certain length at one end of the axial-slotted heat pipe shell to be connected with the temperature equalization joint to form a cylindrical end with a certain length; processing a groove with a certain length inside another end of the axial-slotted heat pipe shell not to be connected with the temperature equalization joint to install the filling end cover or the sealing end cover;

step (1.2) on the basis of the step (1.1), processing at least three circumferential slots spaced at a certain spacing at the end of the axial-slotted heat pipe shell to be connected to the temperature equalization joint, where the plane in which the circumferential slots lie is orthogonal to the planes in which the axial slots lie;

step (1.3) processing the protective shell of the temperature equalization joint, where an inner diameter of the protective shell is the same as an outer diameter of the cylindrical end of the axial-slotted heat pipe processed in the step (1); and

step (1.4) processing the main pipe shell and the branch pipe shell of the temperature equalization joint; where outer diameters of the main pipe shell and the branch pipe shell are the same as an outer diameter of the protective shell of the temperature equalization joint, axial section sizes of the main pipe shell and the branch pipe shell (including the number of the axial slots, the size of the axial slots and the size of the stream passages) are exactly the same as axial section sizes of the axial-slotted pipe shell.

The step 2 of processing a sealing end cover, a filling end cover and a filling pipe specifically includes the following steps:

step (2.1) processing the sealing end cover, where the sealing end cover has a cylindrical structure, and an outer diameter of the sealing end cover is the same as an inner diameter of the groove processed on the axial-slotted heat pipe shell;

step (2.2) processing the filling end cover, where the filling end cover has a cylindrical structure, and an outer diameter of the filling end cover is the same as the inner diameter of the groove processed on the axial-slotted heat pipe shell; and boring a through hole in the middle of the filling end cover; and

step (2.3) processing the filling pipe, where an outer diameter of the filling pipe is the same as a diameter of the through hole in the middle of the filling end cover.

The step 3 of assembling the axial-slotted heat pipe shells for connection, the protective shell, the main pipe shell and the branch pipe shell of the temperature equalization joint all processed in the step 1, with the filling pipe, the sealing end cover and the filling end cover all processed in the step 2, and completing sealing, specifically includes the following steps:

step (3.1) placing the main pipe shell with a V-shaped groove into the protective shell of the temperature equalization joint first, and then placing the branch pipe shell with a V-shaped protrusion into the protective shell of the temperature equalization joint, where the V-shaped protrusion of the branch pipe shell is inserted into the V-shaped groove of the main pipe shell;

step (3.2) placing metal wire meshes into the main pipe shell and the branch pipe shell, and abutting the metal wire meshes against inner walls of the main pipe shell and the branch pipe shell;

step (3.3) inserting the processed cylindrical ends of the axial-slotted heat pipe shells into the protective shell of the temperature equalization joint, and butting the cylindrical ends with ends of the main pipe shell and the branch pipe shell; ensuring that the axial slots of the axial-slotted heat pipe shell are in one-to-one correspondence with the axial slots of the main pipe shell and the branch pipe shell, so are the steam passages, and ensuring that part of the metal wire meshes in the main pipe shell and the branch pipe shell are in the axial-slotted heat pipes and abut against inner walls of the axial-slotted heat pipes;

step (3.4) fixing the axial-slotted heat pipe shells to the temperature equalization joint by welding and sealing them against each other, in a state where the axial-slotted heat pipe shells are butted with the temperature equalization joint;

step (3.5) placing the filling end cover into the groove at the free end of the axial-slotted heat pipes, and fixing the filling end cover to the groove by welding and sealing them against each other;

step (3.6) inserting the filling pipe into the through hole of the filling end cover, and fixing the filling pipe to the through hole by welding and sealing them against each other; and

step (3.7) placing the sealing end cover into the groove at other free end of the axial-slotted heat pipe shells, and fixing the sealing end cover to the groove by welding and sealing them against each other. After this step, the assembly is finished.

Compared with the conventional technology, the axial-slotted heat pipe with circumferential slots and the assembly method thereof provided according to the present disclosure have the following beneficial effects:

(1) according to the present disclosure, multiple slotted heat pipes may be connected by the temperature equalization joint into the irregular-shaped heat pipe system where internal axial slots and steam passages communicate with each other, which effectively solves the problem of low heat transfer efficiency of the existing heat pipe system with an orthogonal overlap arrangement and improves the heat transfer effect;

(2) according to the present disclosure, multiple slotted heat pipe shells are connected by the temperature equalization joint into the irregular-shaped heat pipe system where internal axial slots and steam passages communicate with each other, the irregular-shaped heat pipe system may be embedded in the satellite deck as a whole to replace the existing heat pipe system with the orthogonal overlap arrangement, and since the pipe shells in the irregular-shaped heat pipe system are all connected by the temperature equalization joints and all are in the same plane, height increase caused by the overlap of two layers of heat pipes is avoided, thereby reducing the thickness of the satellite deck, and saving the weight of the satellite;

(3) according to the present disclosure, ports of the slotted heat pipes and the main pipe shell and the branch pipe shell in the temperature equalization joint are provided with multiple circumferential slots in parallel, and the plane where each of the circumferential slots lies is orthogonal to the planes where the axial slots in the main pipe shell lie, and each of the circumferential slots is in communication with the axial slots in the main pipe shell, so the liquid working medium can be evenly distributed into the axial slots along the circumferential slots after the liquid working medium is divided;

(4) according to the present disclosure, ports of the inner steam passages of the main pipe shell, the branch pipe shell and one end of the slotted heat pipes are provided with the metal wire meshes, and the metal wire mesh in the steam passage of the main pipe shell is in contact with the metal wire mesh in the steam passage of the branch pipe shell, the metal wire mesh in the slotted heat pipe is in contact with the metal wire meshes in the steam passages of the main pipe shell and the branch pipe shell, and the capillary force driving the liquid working medium to flow can be increased by the metal wire meshes, so the liquid working medium can be evenly distributed into the axial slots along the metal wire meshes when the liquid working medium is divided.

## BRIEF DESCRIPTION OF THE DRAWINGS

FIG. 1 is a schematic sectional view of a T-shaped connection of three slotted heat pipes with circumferential slots;

FIG. 2 is another schematic sectional view of the T-shaped connection;

FIG. 3 is a schematic view of the T-shaped connection of three slotted heat pipes;

FIG. 4 is a schematic view of an irregular-shaped heat pipe system composed of multiple slotted heat pipes connected through multiple temperature equalization joints;

FIG. 5 is another schematic view of the irregular-shaped heat pipe system composed of multiple slotted heat pipes connected through multiple temperature equalization joints;

FIG. 6 is a schematic view of an arrangement method of orthogonal heat pipes of a deck; and

FIG. 7 shows T-shaped orthogonal heat pipes of a preferred embodiment according to the present disclosure and the test data thereof.

## DETAILED DESCRIPTION OF THE EMBODIMENTS

Specific embodiments of the present disclosure are described below in detail in conjunction with the drawings and examples. The following examples are used to illustrate the present application, and should not be interpreted as a limit to the scope of the present application.

The present disclosure relates to the technical field of heat transfer by means of phase transition, and discloses a slotted heat pipe with circumferential slots and an assembly method thereof. Multiple slotted heat pipes with circumferential slots are connected by temperature equalization joints into an irregular-shaped slotted heat pipe system where internal axial slots and steam passages communicate with each other. A pipe shell of the axial-slotted heat pipe is provided with multiple circumferential slots arranged in parallel at a port connected to the temperature equalization joint, a plane where each of the circumferential slots lies is orthogonal to planes where the axial slots in the axial-slotted pipe shell lie, and the circumferential slots are in communication with the axial slots in the axial-slotted pipe shell. The temperature equalization joint includes a main pipe shell and a branch pipe shell, and axial slots and circumferential slots are provided in both the main pipe shell and the branch pipe shell. Sizes of the axial slots and circumferential slots in the main pipe shell and the branch pipe shell are exactly the same as those of the axial slots and circumferential slots in the axial-slotted heat pipe shell. The irregular-shaped slotted heat pipe system where internal axial slots and steam passages communicate with each other can replace a conventional orthogonal-overlap heat pipe system, avoid the overlap thermal resistance between the heat pipes, greatly improve the heat transfer efficiency and the temperature equalization effect, and reduce the difficulty of arranging the heat pipes.

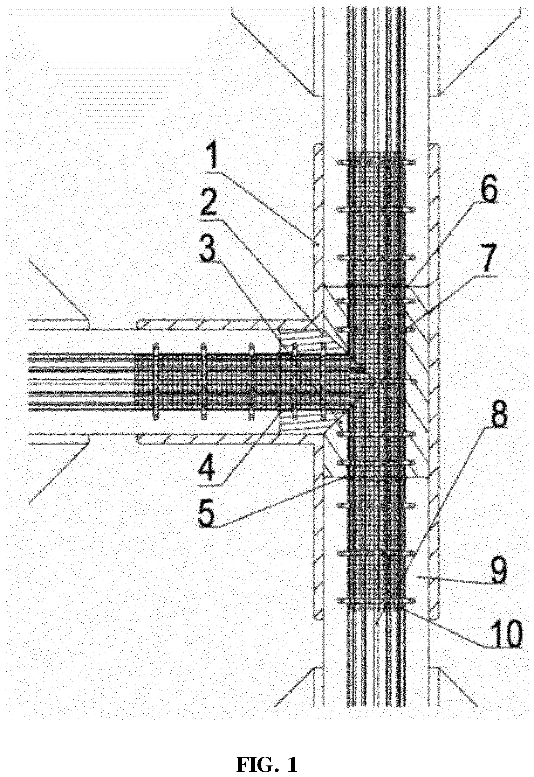

Reference numerals in FIGS. 1 to 8 are: 1: protective shell of temperature equalization joint; 2: branch pipe shell of temperature equalization joint; 3: main pipe shell of temperature equalization joint; 4: end A; 5: end B; 6: end C; 7: circumferential slot; 8: axial slot; 9: slotted heat pipe shell; 10: metal wire mesh; 11: steam passage; 12: filling pipe; 13: filling end cover; 14: sealing end cover of slotted heat pipe shell; 15: Fin; 16: sealing end cover of temperature equalization joint.

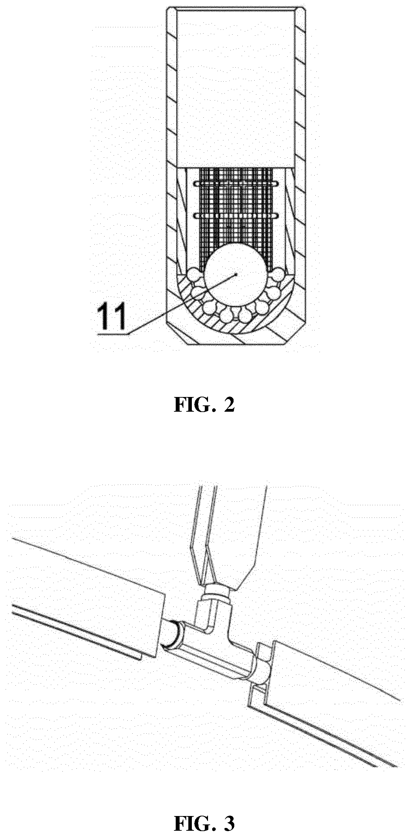

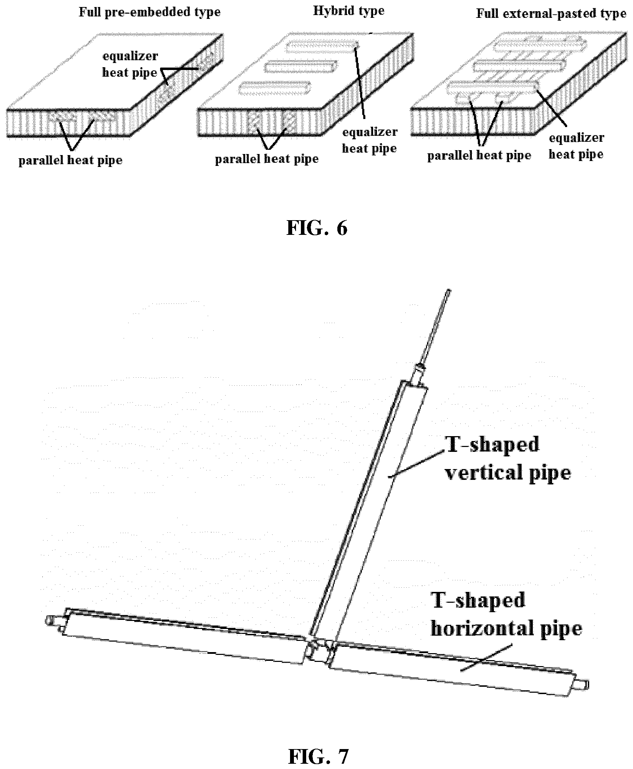

As shown in FIGS. 1 and 3, a slotted heat pipe with circumferential slots is provided according to the present disclosure, and a pipe shell of the slotted heat pipe with circumferential slots includes multiple axial slots, circumferential slots, a steam passage and fins. The pipe shell has a hollow circular structure, and the hollow part is the steam passage (as shown in FIGS. 2 and 7), the multiple axial slots with small-sized openings are spaced apart in parallel in an inner wall of the pipe shell in a circumferential direction, serving as liquid passages. Liquid and steam conduct heat and mass transfer through steam-liquid interfaces at the openings of the axial slots. The fins are located on an outer circumference of the pipe shell and are configured to fixedly install the pipe shell and increase the heat transfer area of the heat pipe. The multiple circumferential slots are arranged in parallel, a plane where each of the circumferential slots lies is orthogonal to planes where the axial slots lie, and the circumferential slots are in communication with the axial slots.

The slotted heat pipe shell with circumferential slots may be formed by extrusion first to obtain the heat pipe shell with axial slots, and then the heat pipe shell is processed by electrical discharge machining to obtain circumferential slots.

As shown in FIGS. 4 and 5, multiple slotted heat pipe shells with circumferential slots are connected by temperature equalization joints to form an irregular-shaped heat pipe system where internal axial slots and steam passages communicate with each other.

As shown in FIG. 1, the temperature equalization joint includes a main pipe shell, a branch pipe shell and a protective shell. The main pipe shell and the branch pipe shell both have a hollow circular structure, and the hollow part is a steam passage, multiple axial slots with small-sized openings are spaced apart in parallel in inner walls of the main pipe shell and the branch pipe shell in a circumferential direction, serving as liquid passages. Liquid and steam conduct heat and mass transfer through steam-liquid interfaces at the openings of the axial slots. The number and size of the axial slots and the size of the steam passages inside the main pipe shell and the branch pipe shell are exactly the same as those of the axial-slotted heat pipe with circumferential slots.

As shown in FIG. 1, multiple circumferential slots are provided in parallel in the inner walls of the main pipe shell and the branch pipe shell. The plane where each of the circumferential slots lies is orthogonal to the planes where the axial slots in the main pipe shell and the branch pipe shell lie, and each of the circumferential slots is in communication with the axial slots in the main pipe shell and the branch pipe shell. The main pipe shell and the branch pipe shell may be first processed by wire electrical discharge machining to obtain internal axial slots, and then be processed by electrical discharge machining to obtain internal circumferential slots.

As shown in FIG. 1, a V-shaped groove the number of which is the same as that of the branch pipe shell is provided by wire electrical discharge machining in the middle of the main pipe shell. The V-shaped groove penetrates though the axial slots and the stream passage, and the tip of the V-shaped groove is located on an axis of the main pipe shell. A V-shaped protrusion matching the V-shaped groove of the main pipe shell is provided by wire electrical discharge machining at one end of the branch pipe shell, and the tip of the V-shaped protrusion is located on the axis of the main pipe shell.

As shown in FIG. 1, both the main pipe shell and the branch pipe shell are placed inside the protective shell of the temperature equalization joint, and the V-shaped protrusion on the branch pipe shell is inserted into the V-shaped groove of the main pipe shell, to ensure that the axial slots inside the main pipe shell are in one-to-one correspondence and communication with the axial slots inside the branch pipe shell at the V-shaped butt portion, and the steam passage of the main pipe shell and the steam passage of the branch pipe shell are communicated with each other. Metal wire meshes are further laid inside the main pipe shell and the branch pipe shell, and the metal wire meshes abut against the inner walls of the main pipe shell and the branch pipe shell.

As shown in FIG. 1, the slotted heat pipe shell with circumferential slots is inserted into the protective shell of the temperature equalization joint to but with end A of the branch pipe shell; the slotted heat pipe shells with circumferential slots are inserted into the protective shell of the temperature equalization joint to but with end B and end C of the main pipe shell; At the butting portions, the axial slots of the axial-slotted heat pipe shells are in one-to-one correspondence with the axial slots of the main pipe shell and the branch pipe shell, the steam passages of the axial-slotted heat pipe shells are in one-to-one correspondence with the steam passages of the main pipe shell and the branch pipe shell, and part of the metal wire meshes laid on the inner walls of the main pipe shell and the branch pipe shell are extended into the axial-slotted heat pipe shells.

As shown in FIGS. 4 and 5, multiple axial-slotted heat pipe shells with circumferential slots are connected by the multiple temperature equalization joints into an irregular-shaped slotted heat pipe system, the axial-slotted heat pipe shells with circumferential slots may be connected with any two or three of the three connecting ports of the temperature equalization joint, to form an irregular-shaped slotted heat pipe system in a straight shape, an L-shaped cross, a T-shaped cross or a combination of the straight shape, the L-shaped cross, and the T-shaped cross, as shown in FIG. 7. At the butting portions, the axial slots of the axial-slotted heat pipe shells are in one-to-one correspondence with the axial slots of the main pipe shell and the branch pipe shell, the steam passages of the axial-slotted heat pipe shells are in one-to-one correspondence with the steam passages of the main pipe shell and the branch pipe shell, and the metal wire meshes laid on the inner walls of the main pipe shell and the branch pipe shell are extended into the axial-slotted heat pipe shells, so that the axial slots and steam passages inside the irregular-shaped slotted heat pipe system communicate with each other, and a steam-liquid phase-transition heat transfer working medium inside the irregular-shaped heat pipe system can circulate in the whole irregular-shaped heat pipe system.

As shown in FIGS. 4 and 5, the connections of the axial-slotted heat pipe shells and the temperature equalization joints need to be welded and sealed. In free ends of the axial-slotted heat pipe shells not connected to the temperature equalization joints, at least one free end of the axial-slotted heat pipe shells is provided with a groove having a certain depth, and an inner diameter of the groove is required to have a certain positive allowance. A filling end cover is placed in the groove at this free end, and the filling end cover and the axial-slotted pipe shell are welded into a whole. A through hole is provided in the middle of the filling end cover, and an aperture of the through hole is required to have a certain positive allowance. A filling pipe with an outer diameter matching the through hole is inserted into the through hole, and the filling pipe and the filling end cover are welded into a whole. In other free ends of the axial-slotted heat pipe shells not connected to the temperature equalization joints, grooves having a certain depth are provided, and the diameter of the grooves is required to have a certain positive allowance. Filling end covers are placed in the other free ends, and the filling end covers are welded to the axial-slotted heat pipe shells as a whole. If the temperature equalization joint also has a free end, a sealing end cover matching an inner diameter of the protective shell of the temperature equalization joint is placed in this free end, and the sealing end cover and the temperature equalization joint are weld into a whole.

FIG. 6 shows a schematic view of preferred arrangement methods (orthogonal-on/in-deck) of the slotted heat pipes, including full pre-embedded type, hybrid type, and full external-pasted type. The full pre-embedded type means that the slotted heat pipes are pre-embedded in the deck, and the hybrid type means that a part of the slotted heat pipes are pre-embedded in the deck, and the rest are pasted to the surface of the deck, and the full external-pasted type means that all the slotted heat pipes are pasted to the surface of the deck.

After the welding of all the parts of the irregular-shaped heat pipe system that need to be welded is completed, pressure equipment needs to be connected through a filling pipe, and a pressure test is performed on the irregular-shaped heat pipe system, to ensure that the quality of all welded parts is intact after the pressure test. After the pressure test, helium mass spectra leak detection equipment needs to be connected through the filling pipe 2 to perform helium mass spectra leak detection on the irregular-shaped heat pipe system, and to ensure that the total leak rate meets certain requirements.

After the pressure test and the helium mass spectra leak detection are finished and the test results meet the requirements, the irregular-shaped heat pipe system is filled with the working medium through the filling pipe 2. After the filling is completed, the filling pipe 2 needs to be sealed by cold welding.

All the axial-slotted heat pipe shell, the protective shell of the temperature equalization joint, the main pipe shell and the branch pipe shell of the temperature equalization joint, the filling end cover, the filling pipe and the sealing end cover shall be made of materials compatible with the steam-liquid phase-transition heat transfer working medium.

If a part of the shell of the irregular-shaped slotted heat pipe system is heated, the liquid working medium in the axial slots at the part absorbs heat and evaporates, and transforms into high-pressure steam to enter the steam passage, and the high-pressure steam enters any other part of the irregular-shaped heat pipe system except the heated part through the steam passages communicated with each other, and condenses into the liquid working medium at any other part, and the liquid working medium then flows back to the heated evaporation part along the axial slots communicated with each other by the effect of the capillary suction force generated by the heated evaporation part, and the whole process is cycled on and on, and the heat transfer and temperature equalization of the irregular-shaped heat pipe system are realized through the flow of working medium and the steam-liquid phase transition.

In order to further better realize heat transfer and temperature equalization, the slotted heat pipes with circumferential slots are processed and connected in sequence in the following manner:

step (1) processing the axial-slotted heat pipe shells for connection; and turning off fins by a certain length at one end of the axial-slotted heat pipe shell to be connected with the temperature equalization joint to form a cylindrical end with a certain length, where an outer diameter of the cylindrical end is required to have a negative allowance, so that the cylindrical end can fit the hole of the protective shell of the temperature equalization joint; processing by a lathe a groove having a certain length inside another end of the axial-slotted heat pipe shell not to be connected with the temperature equalization joint, where an inner diameter of the groove is required to have a certain positive allowance, to install the filling end cover or the sealing end cover;

step (2) on the basis of the step (1), processing by means of electrical discharge machining at least three circumferential slots spaced at a certain spacing at the end of the axial-slotted heat pipe shell to be connected to the temperature equalization joint, where the plane in which the circumferential slots lie is orthogonal to the planes in which the axial slots lie;

step (3) processing the protective shell of the temperature equalization joint, where an inner diameter of the protective shell is the same as the outer diameter of the cylindrical end of the axial-slotted heat pipe processed in the step (1), and the inner diameter of the protective shell is required to have a certain positive allowance;

step (4) processing the main pipe shell and the branch pipe shell of the temperature equalization joint; where outer diameters of the main pipe shell and the branch pipe shell are the same as an outer diameter of the protective shell of the temperature equalization joint, and outer diameters of the main pipe shell and the branch pipe shell are required to have a certain negative allowance to fit holes of the protective shell; axial section sizes of the main pipe shell and the branch pipe shell (including the number of the axial slots, the size of the axial slots and the size of the stream passages) are exactly the same as axial section sizes of the axial-slotted pipe shell, and the axial slots may be processed by means of wire electrical discharge machining; circumferential slots are also required to be processed inside the main pipe shell and the branch pipe shell, and the width and depth of the circumferential slots are the same as those of the circumferential slots in the axial-slotted heat pipe shell, and the circumferential slots may be processed by means of electrical discharge machining after the axial slots are processed; the V-shaped groove in the middle of the main pipe shell and the V-shaped protrusion at the end of the branch pipe shell may be processed by means of wire electrical discharge machining, and after the machining, the V-shaped groove in the middle of the main pipe shell shall penetrate though the axial slots and the stream passage, the tip of the V-shaped groove shall be located on an axis of the main pipe shell, and the tip of the V-shaped protrusion of the branch pipe shell shall be located on the axis of the main pipe shell;

step (5) processing the sealing end cover, where the sealing end cover has a cylindrical structure, and an outer diameter of the sealing end cover is the same as an inner diameter of the groove of the axial-slotted heat pipe shell processed in step (1), and the outer diameter of the sealing end cover is required to have a certain negative allowance, and if the temperature equalization joint in the irregular-shaped heat pipe system also has a free end, a sealing end cover matching an inner diameter of the protective shell of the temperature equalization joint is also required to be processed;

step (6) processing the filling end cover, where the filling end cover has a cylindrical structure, and an outer diameter of the filling end cover is the same as the inner diameter of the groove of the axial-slotted heat pipe shell processed in step (1), where the outer diameter of the filling end cover is required to have a certain negative allowance; and boring a through hole in the middle of the filling end cover, where a diameter of the through hole is required to have a certain positive allowance;

step (7) processing the filling pipe, where an outer diameter of the filling pipe is the same as the diameter of the through hole in the middle of the filling end cover, and the outer diameter of the filling pipe is required to have a certain negative allowance;

step (8) placing the main pipe shell with the V-shaped groove into the protective shell of the temperature equalization joint first, and then placing the branch pipe shell with the V-shaped protrusion into the protective shell of the temperature equalization joint, where the V-shaped protrusion of the branch pipe shell is inserted into the V-shaped groove of the main pipe shell to ensure that, at the V-shaped butting portion, the axial slots of the main pipe shell are in one-to-one correspondence with the axial slots of the branch pipe shell, and the steam passage of the main pipe shell and the steam passage of the branch pipe shell are communicated with each other;

step (9) placing metal wire meshes into the main pipe shell and the branch pipe shell, and abutting the metal wire meshes against inner walls of the main pipe shell and the branch pipe shell;

step (10) inserting the cylindrical ends of the axial-slotted heat pipe shells processed in step (1) into the protective shell of the temperature equalization joint, and butting the cylindrical ends with end A of the branch pipe shell and end B and end C of the main pipe shell; ensuring that, at the butting portions, the axial slots of the axial-slotted heat pipe shells are in one-to-one correspondence with the axial slots of the main pipe shell and the branch pipe shell, so are the steam passages, and ensuring that part of the metal wire meshes in the main pipe shell and the branch pipe shell are in the axial-slotted heat pipes and abut against inner walls of the axial-slotted heat pipes;

step (11) fixing the axial-slotted heat pipe shells to the temperature equalization joint by welding and sealing them against each other, in a state where the axial-slotted heat pipe shells are butted with the temperature equalization joint;

step (12) placing the filling end cover into the groove at the free end of the axial-slotted heat pipes, and fixing the filling end cover to the groove by welding and sealing them against each other;

step (13) inserting the filling pipe into the through hole of the filling end cover, and fixing the filling pipe to the through hole by welding and sealing them against each other; and

step (14) placing the sealing end cover into the groove at other free end of the axial-slotted heat pipe shells, and fixing the sealing end cover to the groove by welding and sealing them against each other. If the temperature equalization joint also has a free end, a sealing end cover matching an inner diameter of the protective shell of the temperature equalization joint is required to be inserted into the protective shell of the temperature equalization joint, and to be welded to the protective shell of the temperature equalization joint to form a whole.

While the irregular-shaped slotted heat pipe is working normally, the capillary pressure head ($\Delta P_c$) generated by the heated evaporation part of the pipe shell is the driving force of the inner circulation in the irregular-shaped slotted heat pipe, and the capillary pressure head needs to overcome the frictional resistance loss ($\Delta P_{c\lambda}$) in the liquid passage when the liquid flows back, and the frictional resistance loss ($\Delta P_{v\lambda}$) of the steam working medium in the steam passage. Due to the diversion of the working medium in the steam passage and the liquid passage at the temperature equalization joint, the capillary pressure head also needs to overcome the local resistance loss ($\Delta P_{l\zeta}$) of the liquid working medium at the temperature equalization joint and the local resistance loss ($\Delta P_{v\zeta}$) of the steam working medium at the temperature equalization joint. In ground application, if the irregular-shaped heat pipe system is not placed horizontally, the gravity of the working medium itself also needs to be considered. The gravity of the steam working medium can be ignored, only the gravity effect ($\Delta P_{lg}$) of the liquid working medium needs to be considered. $\Delta P_{lg}$ may be positive or negative, which depends on the orientation of the irregular-shaped slotted heat pipe system and the heated part of the pipe shell. If the irregular-shaped slotted heat pipe system is not placed horizontally and the heated part is at a lowest end of the irregular-shaped slotted heat pipe system, the liquid working medium everywhere is subjected to gravity auxiliary effect ($\Delta P_{lsg}$) when flowing. If the heated part is in the middle of the irregular-shaped slotted heat pipe system, the liquid above the heated part will be subjected to the gravity auxiliary effect ($\Delta P_{lsg}$) when the liquid flows back, and the liquid below the heated part will be subjected to gravity hindering effect ($\Delta P_{lxg}$) when the liquid flows back.

The irregular-shaped heat pipe system preferably satisfies the following pressure balance formula to improve the heat transfer capacity and temperature equalization performance of the irregular-shaped heat pipe system, that is:

$$\Delta P_c + \Delta P_{lsg} \geq \Delta P_{l\lambda} + \Delta P_{l\xi} + \Delta P_{v\lambda} + \Delta P_{v\xi} + \Delta P_{lxg} \qquad (1)$$

In the formula (1), $\Delta P_c$ is related to the opening width ($\omega$) of the axial slot, the liquid surface tension ($\sigma$), and the contact angle ($\theta$) between the liquid working medium and the opening wall surface of the axial slot. The following formula is preferred:

$$\Delta P_c = \frac{4\sigma \cos \theta}{\omega} \qquad (2)$$

In a case that the contact angle $\theta = 0^0$, the capillary pressure head reaches the maximum ($\Delta P_{cmax}$), that is:

$$\Delta P_{cmax} = \frac{2\sigma}{\omega} \qquad (3)$$

In the formula (1), the liquid backflow frictional resistance loss $\Delta P_{l\lambda}$ is related to the geometric dimension of the liquid passage (effective flow length $l_{eff}$, the hydraulic diameter of the liquid flow section $D_l$) and the liquid flow velocity ($v_l$). The following formula is preferred:

$$\Delta P_{l\lambda} = \lambda_l \frac{l_{eff}}{D_l} \frac{\rho_l v_l^2}{2} \qquad (4)$$

In the formula (4), $\rho_l$ is the density of the liquid, and $\lambda_l$ is the flow frictional resistance coefficient of the liquid working medium, which is related to the Reynolds number $R_e$. For the irregular-shaped heat pipe system, the flow of the liquid working medium in the liquid passage is laminar flow, and the relationship between $\lambda_l$ and $R_e$ is preferably as follows:

$$\lambda_l = \frac{64}{R_e} \tag{5}$$

The Reynolds number $R_e$ is related to the flow velocity $v_l$, the density $\rho_l$ and the viscosity coefficient $\mu_l$ of the liquid working medium. The following formula is preferred:

$$R_e = \frac{\rho_l v_l D_l}{\mu_l} \tag{6}$$

The following formula can be obtained by combining formulas (4), (5) and (6):

$$\Delta P_{l\lambda} = \frac{32\mu_l l_{eff} v_l}{D_l^2} \tag{7}$$

In the formula (1), the liquid backflow local resistance loss $\Delta P_{l\zeta}$ at the temperature equalization joint is related to the geometric dimension of the liquid passage (effective flow length $l_{effj}$, the hydraulic diameter of the liquid flow section $D_{lj}$) at the temperature equalization joint and the liquid flow velocity ($v_{lj}$). The following formula is preferred:

$$\Delta P_{l\xi} = \xi_l \frac{l_{effj}}{D_{lj}} \frac{\rho_l v_{lj}^2}{2} \tag{8}$$

In the formula (8), $\xi_l$ is the local pressure loss coefficient of the liquid flow at the temperature equalization joint, and is related to the structure and size of the temperature equalization joint, and $\xi_l$ needs to be determined through experiments.
In the same way, the following formulas can be obtained:

$$\Delta P_{v\lambda} = \frac{32\mu_v l_{eff} v_v}{D_v^2} \tag{9}$$

$$\Delta P_{v\xi} = \xi_v \frac{l_{effj}}{D_{vj}} \frac{\rho_v v_{vj}^2}{2} \tag{10}$$

In the formulas (9) and (10), $\mu_v$ is the steam viscosity coefficient, $\rho_v$ is the steam density, $v_v$ is the steam flow velocity, $D_v$ is the hydraulic diameter of the steam flow section, $\xi_v$ is the local pressure loss coefficient of the steam passage at the temperature equalization joint and needs to be determined through experiments, $l_{effv}$ is the effective steam flow length at the temperature equalization joint, $D_{vj}$ is the hydraulic diameter of the steam flow section at the temperature equalization joint, and $v_{vj}$ is the steam flow velocity at the temperature equalization joint.
Without considering the gravity of the working medium, the derivation from the above formulas shows that, in a case that the flow section size of the working medium and the type of the working medium are constant, the greater the flow velocities of the liquid and steam working mediums, the greater the frictional resistance loss and the local resistance loss at the temperature equalization joint. The flow velocities of the liquid and steam working mediums are related to the flow of the working medium participating in the circulation, and the flow of the working medium participating in the circulation depends on the heating power received by the heated part. The greater the heating power of the heated part, the greater the flow of the working medium participating the circulation, and the greater the flow velocities of the liquid and steam working mediums. When the heating power reaches a certain value ($Q_{max}$), the flow velocities of the fluid and steam working mediums reach a certain value. At this time, the maximum capillary pressure head generated at the evaporation part is exactly equal to the sum of the frictional resistance loss and the local resistance loss caused by the backflow of the liquid working medium and the flow of the steam working medium. If the heating power is further increased at this time, the maximum capillary pressure head will be insufficient to overcome the sum of the frictional resistance loss and the local resistance loss caused by the backflow of the liquid working medium and the flow of the steam working medium, and the working medium in the heat pipe system cannot circulate, and the heat pipe system losses the heat transfer effect. $Q_{max}$ is the maximum heat transfer capacity of the heat pipe system without considering the effect of the gravity. In order to increase $Q_{max}$ of the heat pipe system, it is required to increase the maximum capillary pressure head provided by the capillary core as much as possible, and reduce the frictional resistance loss of the working medium and the local resistance loss at the temperature equalization joint as much as possible. In a case that the gravity is also considered, the maximum heat transfer capacity of the device will be greater than $Q_{max}$ if the gravity plays a role of assisting liquid backflow, or the maximum heat transfer capacity of the device will be less than $Q_{max}$ if the gravity plays a role of hindering the liquid backflow.

In order to improve the heat transfer capacity of the irregular-shaped heat pipe system as much as possible, the preferred solution for the slotted heat pipe with circumferential slots and the temperature equalization joint is: the axial slot inside the pipe shell has an $\Omega$ shape with a relative small opening size, and the liquid flow section is basically circular to minimize the frictional resistance loss of the liquid flow; the section of the steam passage is also circular; three circumferential slots with the same width as the opening size of the axial slot and spaced apart by a spacing of 5mm are provided at the end where the axial-slotted heat pipe shell is butted with the temperature equalization joint; five circumferential slots with the same width as the opening size of the axial slot and spaced apart by a spacing of 3mm are provided in the main pipe shell of the temperature equalization joint; two circumferential slots with the same width as the opening size of the axial slot and spaced apart by a spacing of 3mm are provided in the branch pipe shell of the temperature equalization joint. The mesh width of the metal wire meshes inside the temperature equalization joint is the same as the opening size of the axial slot.

In order to improve the heat transfer capacity of the irregular-shaped heat pipe system as much as possible, in ground application, the preferred arrangement is a planar structure to avoid the loss caused by the gravity; or an arrangement in which the heated part is at the lowest end of the heat pipe system to allow the gravity to assist the liquid backflow if the irregular-shaped heat pipe system is placed non-horizontally.

A further preferred solution is as follows. The slotted heat pipes with circumferential slots are assembled according to the following solution to improve the temperature equalization performance and the heat transfer efficiency of the slotted heat pipes. The following solution includes the following sequential steps:

step (1) processing the axial-slotted heat pipe shells for connection; and turning off fins by a certain length at one end of the axial-slotted heat pipe shell to be connected with the temperature equalization joint to form a cylindrical end with a certain length, where an outer diameter of the cylindrical end is required to have a negative allowance, so that the cylindrical end can fit the hole of the protective shell of the temperature equalization joint; processing by a lathe a groove having a certain length inside another end of the axial-slotted heat pipe shell not to be connected with the temperature equalization joint, where an inner diameter of the groove is required to have a certain positive allowance, to install the filling end cover or the sealing end cover;

step (2) on the basis of the step (1), processing by means of electrical discharge machining at least three circumferential slots spaced at a certain spacing at the end of the axial-slotted heat pipe shell to be connected to the temperature equalization joint, where the plane in which the circumferential slots lie is orthogonal to the planes in which the axial slots lie;

step (3) processing the protective shell of the temperature equalization joint, where an inner diameter of the protective shell is the same as the outer diameter of the cylindrical end of the axial-slotted heat pipe processed in the step (1), and the inner diameter of the protective shell is required to have a certain positive allowance;

step (4) processing the main pipe shell and the branch pipe shell of the temperature equalization joint; where outer diameters of the main pipe shell and the branch pipe shell are the same as an outer diameter of the protective shell of the temperature equalization joint, and outer diameters of the main pipe shell and the branch pipe shell are required to have a certain negative allowance to fit holes of the protective shell; axial section sizes of the main pipe shell and the branch pipe shell (including the number of the axial slots, the size of the axial slots and the size of the stream passages) are exactly the same as axial section sizes of the axial-slotted pipe shell, and the axial slots may be processed by means of wire electrical discharge machining; circumferential slots are also required to be processed inside the main pipe shell and the branch pipe shell, and the width and depth of the circumferential slots are the same as those of the circumferential slots in the axial-slotted heat pipe shell, and the circumferential slots may be processed by means of electrical discharge machining after the axial slots are processed; the V-shaped groove in the middle of the main pipe shell and the V-shaped protrusion at the end of the branch pipe shell may be processed by means of wire electrical discharge machining, and after the machining, the V-shaped groove in the middle of the main pipe shell shall penetrate though the axial slots and the stream passage, the tip of the V-shaped groove shall be located on an axis of the main pipe shell, and the tip of the V-shaped protrusion of the branch pipe shell shall be located on the axis of the main pipe shell;

step (5) processing the sealing end cover, where the sealing end cover has a cylindrical structure, and an outer diameter of the sealing end cover is the same as an inner diameter of the groove of the axial-slotted heat pipe shell processed in step (1), and the outer diameter of the sealing end cover is required to have a certain negative allowance, and if the temperature equalization joint in the irregular-shaped heat pipe system also has a free end, a sealing end cover matching an inner diameter of the protective shell of the temperature equalization joint is also required to be processed;

step (6) processing the filling end cover, where the filling end cover has a cylindrical structure, and an outer diameter of the filling end cover is the same as the inner diameter of the groove of the axial-slotted heat pipe shell processed in step (1), where the outer diameter of the filling end cover is required to have a certain negative allowance; and boring a through hole in the middle of the filling end cover, where a diameter of the through hole is required to have a certain positive allowance;

step (7) processing the filling pipe, where an outer diameter of the filling pipe is the same as the diameter of the through hole in the middle of the filling end cover, and the outer diameter of the filling pipe is required to have a certain negative allowance;

step (8) placing the main pipe shell with the V-shaped groove into the protective shell of the temperature equalization joint first, and then placing the branch pipe shell with the V-shaped protrusion into the protective shell of the temperature equalization joint, where the V-shaped protrusion of the branch pipe shell is inserted into the V-shaped groove of the main pipe shell to ensure that, at the V-shaped butting portion, the axial slots of the main pipe shell are in one-to-one correspondence with the axial slots of the branch pipe shell, and the steam passage of the main pipe shell and the steam passage of the branch pipe shell are communicated with each other;

step (9) placing metal wire meshes into the main pipe shell and the branch pipe shell, and abutting the metal wire meshes against inner walls of the main pipe shell and the branch pipe shell;

step (10) inserting the cylindrical ends of the axial-slotted heat pipe shells processed in step (1) into the protective shell of the temperature equalization joint, and butting the cylindrical ends with end A of the branch pipe shell and end B and end C of the main pipe shell; ensuring that, at the butting portions, the axial slots of the axial-slotted heat pipe shells are in one-to-one correspondence with the axial slots of the main pipe shell and the branch pipe shell, so are the steam passages, and ensuring that part of the metal wire meshes in the main pipe shell and the branch pipe shell are in the axial-slotted heat pipes and abut against inner walls of the axial-slotted heat pipes;

step (11) fixing the axial-slotted heat pipe shells to the temperature equalization joint by welding and sealing them against each other, in a state where the axial-slotted heat pipe shells are butted with the temperature equalization joint;

step (12) placing the filling end cover into the groove at the free end of the axial-slotted heat pipes, and fixing the filling end cover to the groove by welding and sealing them against each other;

step (13) inserting the filling pipe into the through hole of the filling end cover, and fixing the filling pipe to the through hole by welding and sealing them against each other; and

step (14) placing the sealing end cover into the groove at other free end of the axial-slotted heat pipe shells, and fixing the sealing end cover to the groove by welding and sealing them against each other. If the temperature equalization joint also has a free end, a sealing end cover matching an inner diameter of the protective shell of the temperature equalization joint is required to be inserted into the protective shell of the temperature equalization joint, and to be welded to the protective shell of the temperature equalization joint to form a whole.

A preferred assembly method of slotted heat pipes with circumferential slots according to the present disclosure specifically includes the following steps:

step (1) processing the axial-slotted heat pipe shells for connection; and turning off fins by a certain length at one end of the axial-slotted heat pipe shell to be connected with the temperature equalization joint to form a cylindrical end with a certain length, where an outer diameter of the cylindrical end is required to have a negative allowance, so that the cylindrical end can fit the hole of the protective shell of the temperature equalization joint; processing by a lathe a groove having a certain length inside another end of the axial-slotted heat pipe shell not to be connected with the temperature equalization joint, where an inner diameter of the groove is required to have a certain positive allowance, to install the filling end cover or the sealing end cover;

step (2) on the basis of the step (1), processing by means of electrical discharge machining at least three circumferential slots spaced at a certain spacing at the end of the axial-slotted heat pipe shell to be connected to the temperature equalization joint, where the plane in which the circumferential slots lie is orthogonal to the planes in which the axial slots lie;

step (3) processing the protective shell of the temperature equalization joint, where an inner diameter of the protective shell is the same as the outer diameter of the cylindrical end of the axial-slotted heat pipe processed in the step (1), and the inner diameter of the protective shell is required to have a certain positive allowance;

step (4) processing the main pipe shell and the branch pipe shell of the temperature equalization joint; where outer diameters of the main pipe shell and the branch pipe shell are the same as an outer diameter of the protective shell of the temperature equalization joint, and outer diameters of the main pipe shell and the branch pipe shell are required to have a certain negative allowance to fit holes of the protective shell; axial section sizes of the main pipe shell and the branch pipe shell (including the number of the axial slots, the size of the axial slots and the size of the stream passages) are exactly the same as axial section sizes of the axial-slotted pipe shell, and the axial slots may be processed by means of wire electrical discharge machining; circumferential slots are also required to be processed inside the main pipe shell and the branch pipe shell, and the width and depth of the circumferential slots are the same as those of the circumferential slots in the axial-slotted heat pipe shell, and the circumferential slots may be processed by means of electrical discharge machining after the axial slots are processed; the V-shaped groove in the middle of the main pipe shell and the V-shaped protrusion at the end of the branch pipe shell may be processed by means of wire electrical discharge machining, and after the machining, the V-shaped groove in the middle of the main pipe shell shall penetrate though the axial slots and the stream passage, the tip of the V-shaped groove shall be located on an axis of the main pipe shell, and the tip of the V-shaped protrusion of the branch pipe shell shall be located on the axis of the main pipe shell;

step (5) processing the sealing end cover, where the sealing end cover has a cylindrical structure, and an outer diameter of the sealing end cover is the same as an inner diameter of the groove of the axial-slotted heat pipe shell processed in step (1), and the outer diameter of the sealing end cover is required to have a certain negative allowance, and if the temperature equalization joint in the irregular-shaped heat pipe system also has a free end, a sealing end cover matching an inner diameter of the protective shell of the temperature equalization joint is also required to be processed;

step (6) processing the filling end cover, where the filling end cover has a cylindrical structure, and an outer diameter of the filling end cover is the same as the inner diameter of the groove of the axial-slotted heat pipe shell processed in step (1), where the outer diameter of the filling end cover is required to have a certain negative allowance; and boring a through hole in the middle of the filling end cover, where a diameter of the through hole is required to have a certain positive allowance;

step (7) processing the filling pipe, where an outer diameter of the filling pipe is the same as the diameter of the through hole in the middle of the filling end cover, and the outer diameter of the filling pipe is required to have a certain negative allowance;

step (8) placing the main pipe shell with the V-shaped groove into the protective shell of the temperature equalization joint first, and then placing the branch pipe shell with the V-shaped protrusion into the protective shell of the temperature equalization joint, where the V-shaped protrusion of the branch pipe shell is inserted into the V-shaped groove of the main pipe shell to ensure that, at the V-shaped butting portion, the axial slots of the main pipe shell are in one-to-one correspondence with the axial slots of the branch pipe shell, and the steam passage of the main pipe shell and the steam passage of the branch pipe shell are communicated with each other;

step (9) placing metal wire meshes into the main pipe shell and the branch pipe shell, and abutting the metal wire meshes against inner walls of the main pipe shell and the branch pipe shell;

step (10) inserting the cylindrical ends of the axial-slotted heat pipe shells processed in step (1) into the protective shell of the temperature equalization joint, and butting the cylindrical ends with end A of the branch pipe shell and end B and end C of the main pipe shell; ensuring that, at the butting portions, the axial slots of the axial-slotted heat pipe shells are in one-to-one correspondence with the axial slots of the main pipe shell and the branch pipe shell, so are the steam passages, and ensuring that part of the metal wire meshes in the main pipe shell and the branch pipe shell are in the axial-slotted heat pipes and abut against inner walls of the axial-slotted heat pipes;

step (11) fixing the axial-slotted heat pipe shells to the temperature equalization joint by welding and sealing them against each other, in a state where the axial-slotted heat pipe shells are butted with the temperature equalization joint;

step (12) placing the filling end cover into the groove at the free end of the axial-slotted heat pipes, and fixing the filling end cover to the groove by welding and sealing them against each other;

step (13) inserting the filling pipe into the through hole of the filling end cover, and fixing the filling pipe to the through hole by welding and sealing them against each other; and

step (14) placing the sealing end cover into the groove at other free end of the axial-slotted heat pipe shells, and fixing the sealing end cover to the groove by welding and sealing them against each other. If the temperature equalization joint also has a free end, a sealing end cover matching an inner diameter of the protective shell of the temperature equalization joint is required to be inserted into the protective shell of the temperature equalization joint, and to be welded to the protective shell of the temperature equalization joint to form a whole.

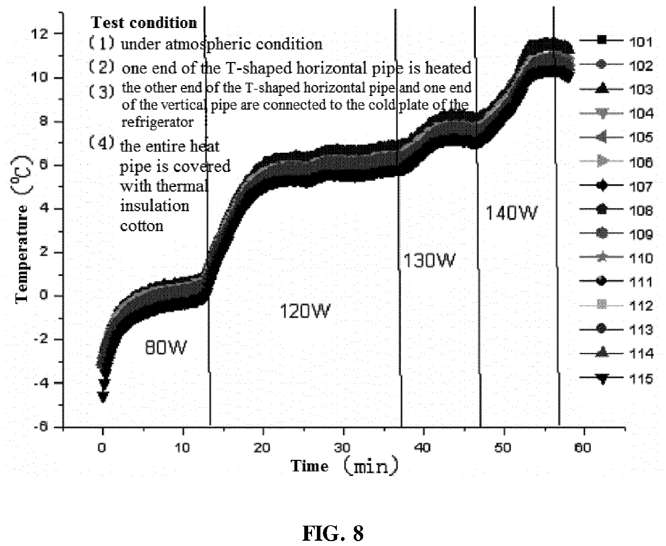

FIG. 8 shows the test data diagram of a truss-type steam-liquid phase-transition heat transfer device composed of the preferred slotted heat pipes with the axial slots according to the present disclosure under atmospheric condition. In the experiment, the truss-type steam-liquid phase-transition heat transfer device has a horizontal truss structure. One slotted heat pipe in the device is heated, and other slotted heat pipes at a certain distance from the heated slotted heat pipe are connected to a cold plate of a refrigerator, and the whole device is covered with thermal insulation cotton. The test result shows that the device composed of the slotted heat pipes with axial slots according to the present disclosure has good heat transfer capacity, and the efficiency of heat transfer is significantly improved.

In the present disclosure, ports of the slotted heat pipes and the main pipe shell and the branch pipe shell in the temperature equalization joint are provided with multiple circumferential slots in parallel, and the plane where each of the circumferential slots lies is orthogonal to the planes where the axial slots in the main pipe shell lie, and each of the circumferential slots is in communication with the axial slots in the main pipe shell, so the liquid working medium can be evenly distributed into the axial slots along the circumferential slots after the liquid working medium is divided; In the present disclosure, ports of the inner steam passages of the main pipe shell, the branch pipe shell and one end of the slotted heat pipes are provided with the metal wire meshes, and the metal wire mesh in the steam passage of the main pipe shell is in contact with the metal wire mesh in the steam passage of the branch pipe shell, the metal wire mesh in the slotted heat pipe is in contact with the metal wire meshes in the steam passages of the main pipe shell and the branch pipe shell, and the capillary force driving the liquid working medium to flow can be increased by the metal wire meshes, so the liquid working medium can be evenly distributed into the axial slots along the metal wire meshes when the liquid working medium is divided.

In the present disclosure, multiple slotted heat pipes may be connected by the temperature equalization joint into the irregular-shaped heat pipe system where internal axial slots and steam passages communicate with each other, which effectively solves the problem of low heat transfer efficiency of the existing heat pipe system with an orthogonal overlap arrangement and improves the heat transfer effect. In the present disclosure, multiple slotted heat pipe shells are connected by the temperature equalization joint into the irregular-shaped heat pipe system where internal axial slots and steam passages communicate with each other, the irregular-shaped heat pipe system may be embedded in the satellite deck as a whole to replace the existing heat pipe system with the orthogonal overlap arrangement, and since the pipe shells in the irregular-shaped heat pipe system are all connected by the temperature equalization joints and all are in the same plane, height increase caused by the overlap of two layers of heat pipes is avoided, thereby reducing the thickness of the satellite deck, and saving the weight of the satellite.

## Claims

1.  A slotted heat pipe with circumferential slots, wherein a pipe shell (9) of the slotted heat pipe with circumferential slots comprises a plurality of axial slots (8), circumferential slots (7), a steam passage (11) and fins (15); the pipe shell (9) has a hollow circular structure, and the hollow part is the steam passage (11), the plurality of axial slots (8) are spaced apart in parallel in an inner wall of the pipe shell (9) in a circumferential direction, and are configured to serve as liquid passages, and liquid and steam conduct heat and mass transfer through steam-liquid interfaces at openings of the axial slots (8); the fins (15) are located on an outer circumference of the pipe shell (9) and are configured to fixedly install the pipe shell (9) and increase a heat transfer area of the heat pipe; a plurality of circumferential slots (7) are arranged in parallel, a plane in which each of the circumferential slots (7) lies is orthogonal to planes in which the axial slots lie (8), and the circumferential slots (7) are in communication with the axial slots (8),

wherein a plurality of slotted heat pipes with circumferential slots are connected by temperature equalization joints into an irregular-shaped slotted heat pipe system in which internal axial slots and steam passages are in communication with each other,

wherein the temperature equalization joint comprises a main pipe shell (3), a branch pipe shell (2) and a protective shell (1); the main pipe shell (3) and the branch pipe shell (2) both have a hollow circular structure, and the hollow part is a steam passage, a plurality of axial slots with small-sized openings are spaced apart in parallel in inner walls of the main pipe shell (3) and the branch pipe shell (2) in a circumferential direction, and are configured to serve as liquid passages, and liquid and steam conduct heat and mass transfer through steam-liquid interfaces at the openings of the axial slots; axial section sizes of the main pipe shell (3) and the branch pipe shell (2) are exactly the same as axial section sizes of the axial-slotted pipe; both the main pipe shell (3) and the branch pipe shell (2) are arranged inside the protective shell.

2. The slotted heat pipe with circumferential slots according to claim 1, wherein a plurality of circumferential slots are provided in parallel in the inner walls of the main pipe shell (3) and the branch pipe shell (2); a plane in which each of the circumferential slots lies is orthogonal to planes in which the axial slots in the main pipe shell (3) and the branch pipe shell lie (2), and each of the circumferential slots is in communication with the axial slots in the main pipe shell (3) and the branch pipe shell (2).

3. The slotted heat pipe with circumferential slots according to claim 1, wherein the main pipe shell (3) is provided with a V-shaped groove the number of which is the same as the number of the branch pipe shell (2), the V-shaped groove is configured to penetrate though the axial slots and the stream passage, the tip of the V-shaped groove is located on an axis of the main pipe shell, and two ends of the main pipe shell (3) are respectively butted with two axial-slotted heat pipes with circumferential slots.

4. The slotted heat pipe with circumferential slots according to claim 1, wherein the branch pipe shell (2) is provided with a V-shaped protrusion matching a V-shaped groove of the main pipe shell (3), the V-shaped protrusion is connected with the V-shaped groove of the main pipe shell (3), and the tip of the V-shaped protrusion is located on an axis of the main pipe shell (3); one end of the branch pipe shell (2) is butted with one slotted heat pipe with circumferential slots.

5. The slotted heat pipe with circumferential slots according to claim 2, wherein metal wire meshes (10) are provided on the inner walls of the main pipe shell (3) and the branch pipe shell (2).

6. The slotted heat pipe with circumferential slots according to claim 5, wherein the metal wire meshes (10) provided on the inner walls of the main pipe shell (3) and the branch pipe shell (2) are overlapped partially with the axial slots in the slotted heat pipes which are butted with the main pipe shell (3) and the branch pipe shell (2).

7. The slotted heat pipe with circumferential slots according to claim 1, wherein in the irregular-shaped slotted heat pipe system, the slotted heat pipes and the temperature equalization joints are welded and sealed; the slotted heat pipes have at least one free end not connected to the temperature equalization joints, one free end is welded with a filling end cover (13), a through hole is provided on the filling end cover (13), and one filling pipe (12) configured to fill a working medium is welded to the through hole; if the number of the free ends of the axial slotted heat pipes not connected to the temperature equalization joints is greater than two, other free ends are welded with sealing end covers (14) configured to seal the irregular-shaped slotted heat pipe system; after the working medium of the irregular-shaped slotted heat pipe system is filled, the filling pipe (12) is sealed by cold welding.

8. The slotted heat pipe with circumferential slots according to claim 7, wherein in the irregular-shaped slotted heat pipe system, at least three circumferential slots are provided at connection ends of the axial-slotted heat pipes and the temperature equalization joints, at least three circumferential slots are provided on the main pipe shell (3), and at least two circumferential slots are provided on the branch pipe shell (2).

9. The slotted heat pipe with circumferential slots according to claim 7, wherein if a part of the shell of the irregular-shaped slotted heat pipe system is heated, the liquid working medium in the axial slots (8) at the part absorbs heat and evaporates, and transforms into high-pressure steam to enter the steam passage (11), and the high-pressure steam enters any other part of the irregular-shaped heat pipe system except the heated part through the steam passages (11) communicated with each other, and condenses into the liquid working medium at any other part, and the liquid working medium then flows back to the heated evaporation part along the axial slots (8) communicated with each other by an effect of capillary suction force generated by the heated evaporation part, and the whole process is cycled on and on, and the heat transfer and temperature equalization of the irregular-shaped heat pipe system are realized through the flow of working medium and the steam-liquid phase transition.

10. An assembly method of slotted heat pipes with circumferential slots according to any one of claims 1-9, comprising the following steps:

    step 1, providing axial-slotted heat pipe shells (9) to be connected; providing circumferential slots (7) in the pipe shells (9), and providing a protective shell (1), a main pipe shell (3) and a branch pipe shell (2) of a temperature equalization joint;
    step 2, providing a sealing end cover (14), a filling end cover (13) and a filling pipe (12);
    step 3, assembling the axial-slotted heat pipe shells (9) to be connected, the protective shell (1), the main pipe shell (3) and the branch pipe shell (2) of the temperature equalization joint all provided in the step 1, with the filling pipe (12), the sealing end cover (14) and the filling end cover (13) all provided in the step 2, to form and seal a slotted heat pipe with circumferential slots.

11. The assembly method of slotted heat pipes with circumferential slots according to claim 10, wherein the step 1 of providing axial-slotted heat pipe shells to be connected; providing circumferential slots in the pipe shells (9), and providing a protective shell, a main pipe shell (3) and a branch pipe shell (2) of a temperature equalization joint, specifically comprises the following steps:

    step 1.1, providing the axial-slotted heat pipe shells (9) to be connected; turning off fins by a certain length at one end of the axial-slotted heat pipe shell (9) to be connected with the temperature equalization joint to form a cylindrical end with a certain length; providing a groove with a certain length inside another end of the axial-slotted heat pipe shell (9) not to be connected with the temperature equalization joint to install the filling end cover (13) or the sealing end cover (14);
    step 1.2, on the basis of the step 1.1, providing at least three circumferential slots spaced at a certain spacing at the end of the axial-slotted heat pipe shell (9) to be connected to the temperature equalization joint, wherein the plane in which the circumferential slots lie is orthogonal to the planes in which the axial slots lie;
    step 1.3, providing the protective shell of the temperature equalization joint, wherein an inner diameter of the protective shell is the same as an outer diameter of the cylindrical end of the axial-slotted heat pipe provided in the step 1; and
    step 1.4, providing the main pipe shell (3) and the branch pipe shell (2) of the temperature equalization joint; wherein outer diameters of the main pipe shell (3) and the branch pipe shell (2) are the same as an outer diameter of the protective shell of the temperature equalization joint, axial section sizes of the main pipe shell (3) and the branch pipe shell (2) (comprising the number of the axial slots, the size of the axial slots and the size of the stream passages) are exactly the same as axial section sizes of the axial-slotted pipe shell (9).

12. The assembly method of slotted heat pipes with circumferential slots according to claim 10, wherein the step 2 of providing a sealing end cover (14), a filling end cover (13) and a filling pipe (12) specifically comprises the following steps:

    step 2.1, providing the sealing end cover (14), wherein the sealing end cover (14) has a cylindrical structure, and an outer diameter of the sealing end cover (14) is the same as an inner diameter of the groove provided on the axial-slotted heat pipe shell (9);
    step 2.2, providing the filling end cover (13), wherein the filling end cover (13) has a cylindrical structure, and an outer diameter of the filling end cover (13) is the same as the inner diameter of the groove provided on the axial-slotted heat pipe shell (9); and boring a through hole in the middle of the filling end cover (13); and
    step 2.3, providing the filling pipe (12), wherein an outer diameter of the filling pipe (12) is the same as a diameter of the through hole in the middle of the filling end cover (13).

13. The assembly method of slotted heat pipes with circumferential slots according to claim 10, wherein the step 3 of assembling the axial-slotted heat pipe shells (9) to be connected, the protective shell, the main pipe shell (3) and the branch pipe shell (2) of the temperature equalization joint all provided in the step 1, with the filling pipe (12), the sealing end cover (14) and the filling end cover (13) all provided in the step 2, and completing sealing, specifically comprises the following steps:

step 3.1, placing the main pipe shell (3) with a V-shaped groove into the protective shell of the temperature equalization joint first, and then placing the branch pipe shell (2) with a V-shaped protrusion into the protective shell of the temperature equalization joint, wherein the V-shaped protrusion of the branch pipe shell (2) is inserted into the V-shaped groove of the main pipe shell (3);

step 3.2, placing metal wire meshes (10) into the main pipe shell (3) and the branch pipe shell (2), and abutting the metal wire meshes (10) against inner walls of the main pipe shell (3) and the branch pipe shell (2);

step 3.3, inserting the provided cylindrical ends of the axial-slotted heat pipe shells (9) into the protective shell of the temperature equalization joint, and butting the cylindrical ends with ends of the main pipe shell (3) and the branch pipe shell (2); ensuring that the axial slots of the axial-slotted heat pipe shell (9) are in one-to-one correspondence with the axial slots of the main pipe shell (3) and the branch pipe shell (2), so are the steam passages, and ensuring that part of the metal wire meshes (10) in the main pipe shell (3) and the branch pipe shell (2) are in the axial-slotted heat pipes and abut against inner walls of the axial-slotted heat pipes;

step 3.4, welding and fixing the axial-slotted heat pipe shells (9) to the temperature equalization joint and sealing them against each other, in a state in which the axial-slotted heat pipe shells (9) are butted with the temperature equalization joint;

step 3.5, placing the filling end cover (13) into the groove at the free end of the axial-slotted heat pipes, and fixing the filling end cover (13) to the groove by welding and sealing them against each other;

step 3.6, inserting the filling pipe (12) into the through hole of the filling end cover (13), and fixing the filling pipe (12) to the through hole by welding and sealing them against each other; and

step 3.7, placing the sealing end cover (14) into the groove at other free end of the axial-slotted heat pipe shells (9), and fixing the sealing end cover (14) to the groove by welding and sealing them against each other; and after this step, the assembly is finished.

## Patentansprüche

1. Geschlitztes Wärmerohr mit Umfangsschlitzen, wobei ein Rohrmantel (9) des geschlitzten Wärmerohrs mit Umfangsschlitzen eine Vielzahl von axialen Schlitzen (8), Umfangsschlitzen (7), einen Dampfkanal (11) und Rippen (15) umfasst; der Rohrmantel (9) eine hohle kreisförmige Struktur aufweist und der hohle Teil der Dampfkanal (11) ist, die Vielzahl von axialen Schlitzen (8) in einer Innenwand des Rohrmantels (9) in einer Umfangsrichtung parallel voneinander beabstandet sind und derart konfiguriert sind, dass sie als Flüssigkeitskanäle dienen, und Flüssigkeit und Dampf Wärme- und Massenübertragung durch Dampf-Flüssigkeits-Grenzflächen an Öffnungen der axialen Schlitze (8) leiten; die Rippen (15) sich an einem Außenumfang des Rohrmantels (9) befinden und derart konfiguriert sind, dass sie den Rohrmantel (9) fest installieren und eine Wärmeübertragungsfläche des Wärmerohrs vergrößern; eine Vielzahl von Umfangsschlitzen (7) parallel angeordnet sind, eine Ebene, in der jeder der Umfangsschlitze (7) liegt, orthogonal zu Ebenen ist, in denen die axialen Schlitze (8) liegen, und die Umfangsschlitze (7) mit den axialen Schlitzen (8) in Verbindung stehen,

wobei eine Vielzahl von geschlitzten Wärmerohren mit Umfangsschlitzen durch Temperaturausgleichsfugen zu einem unregelmäßig geformten geschlitzten Wärmerohrsystem verbunden sind, in dem innere axiale Schlitze und Dampfkanäle miteinander in Verbindung stehen,

wobei die Temperaturausgleichsfuge einen Hauptrohrmantel (3), einen Nebenrohrmantel (2) und einen Schutzmantel (1) umfasst; der Hauptrohrmantel (3) und der Nebenrohrmantel (2) beide eine hohle kreisförmige Struktur aufweisen und der hohle Teil ein Dampfkanal ist, eine Vielzahl von axialen Schlitzen mit kleinen Öffnungen in Innenwänden des Hauptrohrmantels (3) und des Nebenrohrmantels (2) in einer Umfangsrichtung parallel voneinander beabstandet sind und derart konfiguriert sind, dass sie als Flüssigkeitskanäle dienen, und Flüssigkeit und Dampf Wärme- und Massenübertragung durch Dampf-Flüssigkeits-Grenzflächen an den Öffnungen der axialen Schlitze leiten; die axialen Teilabschnittdimensionen des Hauptrohrmantels (3) und des Nebenrohrmantels (2) genau den axialen Teilabschnittdimensionen des axial geschlitzten Rohres entsprechen; sowohl der Hauptrohrmantel (3) als auch der Nebenrohrmantel (2) innerhalb des Schutzmantels angeordnet sind.

2. Geschlitztes Wärmerohr mit Umfangsschlitzen nach Anspruch 1, wobei eine Vielzahl von Umfangsschlitzen parallel in den Innenwänden des Hauptrohrmantels (3) und des Nebenrohrmantels (2) bereitgestellt sind; eine Ebene, in der jeder der Umfangsschlitze liegt, orthogonal zu Ebenen ist, in denen die axialen Schlitze in dem Hauptrohrmantel (3) und dem Nebenrohrmantel (2) liegen, und jeder der Umfangsschlitze mit den axialen Schlitzen in dem Hauptrohrmantel (3) und dem Nebenrohrmantel (2) in Verbindung steht.

3. Geschlitztes Wärmerohr mit Umfangsschlitzen nach Anspruch 1, wobei der Hauptrohrmantel (3) mit einer V-förmigen Nut versehen ist, deren Anzahl gleich der Anzahl des Nebenrohrmantels (2) ist, die V-förmige Nut derart konfiguriert ist, dass sie durch die axialen Schlitze und den Strömungskanal hindurchgeht, die Spitze der V-förmigen Nut sich auf einer Achse des Hauptrohrmantels befindet und zwei Enden des Hauptrohrmantels (3) jeweils an zwei axial geschlitzten Wärmerohren mit Umfangsschlitzen anliegen.

4. Geschlitztes Wärmerohr mit Umfangsschlitzen nach Anspruch 1, wobei der Nebenrohrmantels (2) mit einem V-förmigen Vorsprung versehen ist, der zu einer V-förmigen Nut des Hauptrohrmantels (3) passt, der V-förmige Vorsprung mit der V-förmigen Nut des Hauptrohrmantels (3) verbunden ist und die Spitze des V-förmigen Vorsprungs sich auf einer Achse des Hauptrohrmantels (3) befindet; ein Ende des Nebenrohrmantels (2) an einem geschlitzten Wärmerohr mit Umfangsschlitzen anliegt.

5. Geschlitztes Wärmerohr mit Umfangsschlitzen nach Anspruch 2, wobei an den Innenwänden des Hauptrohrmantels (3) und des Nebenrohrmantels (2) Metalldrahtgeflechte (10) bereitgestellt sind.

6. Geschlitztes Wärmerohr mit Umfangsschlitzen nach Anspruch 5, wobei die an den Innenwänden des Hauptrohrmantels (3) und des Nebenrohrmantels (2) bereitgestellten Metalldrahtgeflechte (10) teilweise mit den axialen Schlitzen in den geschlitzten Wärmerohren überlappt werden, die an dem Hauptrohrmantel (3) und dem Nebenrohrmantel (2) anliegen.

7. Geschlitztes Wärmerohr mit Umfangsschlitzen nach Anspruch 1, wobei das unregelmäßig geformte geschlitzte Wärmerohrsystem, die geschlitzten Wärmerohre und die Temperaturausgleichsfugen verschweißt und abgedichtet sind; die geschlitzten Wärmerohre mindestens ein freies Ende aufweisen, das nicht mit den Temperaturausgleichsfugen verbunden ist, ein freies Ende mit einer Befüllungsendabdeckung (13) verschweißt ist, ein Durchgangsloch an der Befüllungsendabdeckung (13) bereitgestellt ist und ein Befüllungsrohr (12), das zum Befüllen eines Arbeitsmediums konfiguriert ist, mit dem Durchgangsloch verschweißt ist; wenn die Anzahl der freien Enden der axialen geschlitzten Wärmerohre, die nicht mit den Temperaturausgleichsfugen verbunden sind, größer als zwei ist, andere freie Enden mit Dichtungsendabdeckungen (14) verschweißt werden, die konfiguriert sind, um das unregelmäßig geformte geschlitzte Wärmerohrsystem abzudichten; nachdem das Arbeitsmedium des unregelmäßig geformten geschlitzten Wärmerohrsystems gefüllt wurde, das Befüllungsrohr (12) durch Kaltschweißen abgedichtet wird.

8. Geschlitztes Wärmerohr mit Umfangsschlitzen nach Anspruch 7, wobei in dem unregelmäßig geformten geschlitzten Wärmerohrsystem mindestens drei Umfangsschlitze an den Verbindungsenden der axial geschlitzten Wärmerohre und der Temperaturausgleichsfugen, mindestens drei Umfangsschlitze am Hauptrohrmantel (3) und mindestens zwei Umfangsschlitze am Nebenrohrmantel (2) bereitgestellt sind.

9. Geschlitztes Wärmerohr mit Umfangsschlitzen nach Anspruch 7, wobei, wenn ein Teil des Mantels des unregelmäßig geformten geschlitzten Wärmerohrsystems erwärmt wird, das flüssige Arbeitsmedium in den axialen Schlitzen (8) an dem Teil Wärme absorbiert und verdampft und sich in Hochdruckdampf umwandelt, um in den Dampfkanal (11) einzutreten, und der Hochdruckdampf in jeden anderen Teil des unregelmäßig geformten Wärmerohrsystems außer dem erwärmten Teil durch die miteinander verbundenen Dampfkanäle (11) eintritt, und in das flüssige Arbeitsmedium an irgendeinem anderen Teil kondensiert, und das flüssige Arbeitsmedium dann zurück zu dem erwärmten Verdampfungsteil entlang der axialen Schlitze (8), die miteinander verbunden sind, durch die Wirkung der Kapillarsaugkraft, die durch den beheizten Verdampfungsteil erzeugt wird, fließt, und der ganze Prozess immer weiter fortgeführt wird, und die Wärmeübertragung und der Temperaturausgleich des unregelmäßig geformten Wärmerohrsystems durch den Fluss des Arbeitsmediums und den Dampf-Flüssigkeits-Phasenübergang realisiert werden.

10. Verfahren zum Zusammenbauen von geschlitzten Wärmerohren mit Umfangsschlitzen nach einem der Ansprüche 1 bis 9, umfassend die folgenden Schritte:

Schritt 1, Bereitstellen von axial geschlitzten, zu verbindenden Wärmerohrmänteln (9); Bereitstellen von Umfangsschlitzen (7) in den Rohrmänteln (9), und Bereitstellen eines Schutzmantels (1), eines Hauptrohrmantels (3) und eines Nebenrohrmantels (2) einer Temperaturausgleichsfuge;
Schritt 2, Bereitstellen einer Dichtungsendabdeckung (14), einer Befüllungsendabdeckung (13) und eines Befüllungsrohrs (12);

Schritt 3, Zusammenbauen der zu verbindenden axial geschlitzten Wärmerohrmäntel (9), des Schutzmantels (1), des Hauptrohrmantels (3) und des Nebenrohrmantels (2) der Temperaturausgleichsfuge, die alle im Schritt 1 bereitgestellt sind, mit dem Befüllungsrohr (12), der Dichtungsendabdeckung (14) und der Befüllungsendabdeckung (13), die alle im Schritt 2 bereitgestellt sind, zur Bildung und Abdichtung eines geschlitzten Wärmerohrs mit Umfangsschlitzen.

11. Verfahren zum Zusammenbauen von geschlitzten Wärmerohren mit Umfangsschlitzen nach Anspruch 10, wobei im Schritt 1 zu verbindende, axial geschlitzte Wärmerohrmäntel bereitgestellt werden; Bereitstellen von Umfangsschlitzen in den Rohrmänteln (9) und Bereitstellen eines Schutzmantels, eines Hauptrohrmantels (3) und eines Nebenrohrmantels (2) einer Temperaturausgleichsfuge, was insbesondere die folgenden Schritte umfasst:

Schritt 1.1, Bereitstellen der axial geschlitzten Wärmerohrmäntel (9), die verbunden werden sollen; Abdrehen von Rippen um eine bestimmte Länge an einem Ende des axial geschlitzten Wärmerohrmantels (9), der mit der Temperaturausgleichsfuge verbunden werden soll, um ein zylindrisches Ende mit einer bestimmten Länge zu bilden; Bereitstellen einer Nut mit einer bestimmten Länge innerhalb eines anderen Endes des axial geschlitzten Wärmerohrmantels (9), der nicht mit der Temperaturausgleichsfuge verbunden werden soll, um die Befüllungsendabdeckung (13) oder die Dichtungsendabdeckung (14) zu installieren;

Schritt 1.2, auf der Grundlage des Schrittes 1.1, Bereitstellen von mindestens drei in einem bestimmten Abstand angeordneten Umfangsschlitzen an dem mit der Temperaturausgleichsfuge zu verbindenden Ende des axial geschlitzten Wärmerohrmantels (9), wobei die Ebene, in der die Umfangsschlitze liegen, orthogonal zu den Ebenen ist, in denen die axialen Schlitze liegen;

Schritt 1.3, Bereitstellen des Schutzmantels der Temperaturausgleichsfuge, wobei ein Innendurchmesser des Schutzmantels der gleiche wie ein Außendurchmesser des zylindrischen Endes des in Schritt 1 bereitgestellten axial geschlitzten Wärmerohrs ist; und

Schritt 1.4, Bereitstellen des Hauptrohrmantels (3) und des Nebenrohrmantels (2) der Temperaturausgleichsfuge; wobei die Außendurchmesser des Hauptrohrmantels (3) und des Nebenrohrmantels (2) die gleichen sind wie ein Außendurchmesser des Schutzmantels der Temperaturausgleichsfuge, die axialen Teilabschnittdimensionen des Hauptrohrmantels (3) und des Nebenrohrmantels (2) (umfassend die Anzahl der axialen Schlitze, die Größe der axialen Schlitze und die Größe der Strömungskanäle) genau die gleichen sind wie die axialen Teilabschnittdimensionen des axial geschlitzten Rohrmantels (9).

12. Verfahren zum Zusammenbauen von geschlitzten Wärmerohren mit Umfangsschlitzen nach Anspruch 10, wobei der Schritt 2 des Bereitstellens einer Dichtungsendabdeckung (14), einer Befüllungsendabdeckung (13) und eines Befüllungsrohrs (12) insbesondere die folgenden Schritte umfasst:

Schritt 2.1, Bereitstellen der Dichtungsendabdeckung (14), wobei die Dichtungsendabdeckung (14) eine zylindrische Struktur aufweist und ein Außendurchmesser der Dichtungsendabdeckung (14) derselbe wie ein Innendurchmesser der an dem axial geschlitzten Wärmerohrmantel (9) bereitgestellten Nut ist;

Schritt 2.2, Bereitstellen der Befüllungsendabdeckung (13), wobei die Befüllungsendabdeckung (13) eine zylindrische Struktur aufweist und ein Außendurchmesser der Befüllungsendabdeckung (13) derselbe ist wie der Innendurchmesser der an dem axial geschlitzten Wärmerohrmantel (9) bereitgestellten Nut; und Bohren eines Durchgangslochs in der Mitte der Befüllungsendabdeckung (13); und

Schritt 2.3, Bereitstellen des Befüllungsrohrs (12), wobei ein Außendurchmesser des Befüllungsrohrs (12) gleich einem Durchmesser des Durchgangslochs in der Mitte der Befüllungsendabdeckung (13) ist.

13. Verfahren zum Zusammenbauen von geschlitzten Wärmerohren mit Umfangsschlitzen nach Anspruch 10, wobei der Schritt 3 des Zusammenbauens der zu verbindenden axial geschlitzten Wärmerohrmäntel (9), des Schutzmantels, des Hauptrohrmantels (3) und des Nebenrohrmantels (2) der Temperaturausgleichsfuge, die alle im Schritt 1 bereitgestellt sind, mit dem Befüllungsrohr (12), der Dichtungsendabdeckung (14) und der Befüllungsendabdeckung (13), die alle im Schritt 2 bereitgestellt sind, und des Fertigstellens der Abdichtung insbesondere die folgenden Schritte umfasst:

Schritt 3.1, Einsetzen des Hauptrohrmantels (3) mit einer V-förmigen Nut in den Schutzmantel der Temperaturausgleichsfuge zuerst, und dann Einsetzen des Nebenrohrmantels (2) mit einem V-förmigen Vorsprung in den Schutzmantel der Temperaturausgleichsfuge, wobei der V-förmige Vorsprung des Nebenrohrmantels (2) in die V-förmige Nut des Hauptrohrmantels (3) eingesetzt wird;

Schritt 3.2, Einsetzen von Metalldrahtgeflechten (10) in den Hauptrohrmantel (3) und den Nebenrohrmantel (2) und Anlegen der Metalldrahtgeflechte (10) an die Innenwände des Hauptrohrmantels (3) und des Nebenrohrmantels (2);

Schritt 3.3, Einführen der bereitgestellten zylindrischen Enden der axial geschlitzten Wärmerohrmäntel (9) in den Schutzmantel der Temperaturausgleichsfuge und Anlegen der zylindrischen Enden an die Enden des Hauptrohrmantels (3) und des Nebenrohrmantels (2); Sicherstellen, dass die axialen Schlitze des axial geschlitzten Wärmerohrmantels (9) eins-zu-eins mit den axialen Schlitzen des Hauptrohrmantels (3) und des Nebenrohrmantels (2) übereinstimmen, und auch die Dampfkanäle übereinstimmen, und Sicherstellen, dass ein Teil der Metalldrahtgeflechte (10) in dem Hauptrohrmantel (3) und dem Nebenrohrmantel (2) in den axial geschlitzten Wärmerohren sind und an den Innenwänden der axial geschlitzten Wärmerohre anliegen;

Schritt 3.4, Verschweißen und Befestigen der axial geschlitzten Wärmerohrmäntel (9) an der Temperaturausgleichsfuge und Abdichten gegeneinander in einem Zustand, in dem die axial geschlitzten Wärmerohrmäntel (9) an der Temperaturausgleichsfuge anliegen;

Schritt 3.5, Einsetzen der Einfüllendabdeckung (13) in die Nut am freien Ende der axial geschlitzten Wärmerohre und Befestigen der Befüllungsendabdeckung (13) in der Nut durch Verschweißen und Abdichten gegeneinander;

Schritt 3.6, Einführen des Befüllungsrohrs (12) in das Durchgangsloch der Befüllungsendabdeckung (13) und Befestigen des Befüllungsrohrs (12) am Durchgangsloch durch Verschweißen und Abdichten gegeneinander; und

Schritt 3.7, Einsetzen der Dichtungsendabdeckung (14) in die Nut am anderen freien Ende der axial geschlitzten Wärmerohrmäntel (9) und Befestigen der Dichtungsendabdeckung (14) in der Nut durch Verschweißen und Abdichten gegeneinander; wobei nach diesem Schritt der Zusammenbau abgeschlossen ist.

**Revendications**

1. Caloduc à fentes ayant des fentes périphériques, dans lequel une gaine de conduit (9) du caloduc à fentes ayant des fentes périphériques comprend une pluralité de fentes axiales (8), des fentes périphériques (7), un passage de vapeur (11) et des ailettes (15) ; la gaine de conduit (9) possède une structure circulaire creuse, et la partie creuse est le passage de vapeur (11), les fentes axiales (8) étant espacées en parallèle dans une paroi interne de la gaine de conduit (9) dans une direction périphérique, et étant configurées pour servir de passages de liquide, et le liquide et la vapeur effectuent un transfert de chaleur et de masse par le biais d'interfaces vapeur-liquide au niveau des ouvertures des fentes axiales (8) ; les ailettes (15) se trouvent sur une périphérie externe de la gaine de conduit (9) et sont configurées pour installer de manière fixe la gaine de conduit (9) et pour augmenter une surface de transfert de chaleur du caloduc ; plusieurs fentes périphériques (7) sont disposées en parallèle, un plan sur lequel chacune des fentes périphériques (7) se trouve étant orthogonal par rapport aux plans sur lesquels les fentes axiales (8) se trouvent, et les fentes périphériques (7) étant en communication avec les fentes axiales (8),

   dans lequel plusieurs caloducs à fentes ayant des fentes périphériques sont reliés par des joints d'égalisation de température en un système de caloduc à fentes de forme irrégulière dans lequel les fentes axiales internes et les passages de vapeur sont en communication les uns avec les autres,

   dans lequel le joint d'égalisation de température comprend une gaine de conduit principal (3), une gaine de conduit de dérivation (2) et une gaine de protection (1) ; la gaine de conduit principal (3) et la gaine de conduit de dérivation (2) possèdent une structure circulaire creuse, et la partie creuse est un passage de vapeur, plusieurs des fentes axiales avec des ouvertures de petite taille sont espacées en parallèle sur les parois internes de la gaine de conduit principal (3) et la gaine de conduit de dérivation (2) dans une direction périphérique, et sont configurées pour servir de passages de liquide, et le liquide et la vapeur effectuent un transfert de chaleur et de masse par le biais d'interfaces vapeur-liquide au niveau des ouvertures des fentes axiales ; les dimensions de section axiale de la gaine de conduit principal (3) et de la gaine de conduit de dérivation (2) sont exactement les mêmes que les dimensions de section axiale du conduit à fentes axiales ; la gaine de conduit principal (3) et la gaine de conduit de dérivation (2) sont prévues à l'intérieur de la gaine de protection.

2. Caloduc à fentes ayant des fentes périphériques selon la revendication 1, dans lequel plusieurs des fentes périphériques sont prévues en parallèle sur les parois internes de la gaine de conduit principal (3) et la gaine de conduit de dérivation (2) ; un plan sur lequel chacune des fentes périphériques se trouve est orthogonal par rapport aux plans sur lesquels les fentes axiales de la gaine de conduit principal (3) et de la gaine de conduit de dérivation (2) se trouvent, et chacune des fentes périphériques est en communication avec les fentes axiales de la gaine de conduit principal (3) et de la gaine de conduit de dérivation (2).

3. Caloduc à fentes ayant des fentes périphériques selon la revendication 1, dans lequel la gaine de conduit principal (3) est équipée de rainures en forme de V dont le nombre est identique au nombre de gaines de conduit de dérivation (2), les rainures en forme de V sont configurées pour pénétrer à travers les fentes axiales et le passage de vapeur, l'extrémité des rainures en forme de V se trouve sur un axe de la gaine de conduit principal, et deux extrémités de la gaine de conduit principal (3) sont respectivement au bout de deux caloducs à fentes axiales ayant des fentes périphériques.

4. Caloduc à fentes ayant des fentes périphériques selon la revendication 1, dans lequel la gaine de conduit de dérivation (2) est équipée d'une saillie en forme de V qui correspond à une rainure en forme de V de la gaine de conduit principal (3), la saillie en forme de V est reliée à la rainure en forme de V de la gaine de conduit principal (3), et l'extrémité de la saillie en forme de V se trouve sur un axe de la gaine de conduit principal (3) ; une extrémité de la gaine de conduit de dérivation (2) se trouve au bout d'un caloduc à fentes ayant des fentes périphériques.

5. Caloduc à fentes ayant des fentes périphériques selon la revendication 2, dans lequel des treillis métalliques (10) sont prévus sur les parois internes de la gaine de conduit principal (3) et la gaine de conduit de dérivation (2).

6. Caloduc à fentes ayant des fentes périphériques selon la revendication 5, dans lequel les treillis métalliques (10) prévus sur les parois internes de la gaine de conduit principal (3) et la gaine de conduit de dérivation (2) sont recouverts partiellement par les fentes axiales dans les caloducs à fentes qui se trouvent au bout de la gaine de conduit principal (3) et de la gaine de conduit de dérivation (2).

7. Caloduc à fentes ayant des fentes périphériques selon la revendication 1, dans lequel, dans le système de caloduc à fentes de forme irrégulière, les caloducs à fentes et les joints d'égalisation de température sont soudés et fermés ; les caloducs à fentes possèdent au moins une extrémité libre non reliée aux joints d'égalisation de température, une extrémité libre est soudée avec un embout de remplissage (13), un orifice traversant est prévu sur l'embout de remplissage (13), et un conduit de remplissage (12) configuré pour le remplissage avec un milieu de fonctionnement est soudé sur l'orifice traversant ; si le nombre d'extrémités libres des caloducs à fentes axiales non reliés aux joints d'égalisation de température est supérieur à deux, d'autres extrémités libres sont soudées avec des embouts d'étanchéité (14) configurés pour fermer le système de caloduc à fentes de forme irrégulière ; après le remplissage du système de caloduc à fentes de forme irrégulière avec le milieu de fonctionnement, le conduit de remplissage (12) est fermé par soudage à froid.

8. Caloduc à fentes ayant des fentes périphériques selon la revendication 7, dans lequel, dans le système de caloduc à fentes de forme irrégulière, au moins trois fentes périphériques sont prévues au niveau des extrémités de raccordement des caloducs à fentes axiales et des joints d'égalisation de température, au moins trois fentes périphériques sont prévues sur la gaine de conduit principal (3), et au moins deux fentes périphériques sont prévues sur la gaine de conduit de dérivation (2).

9. Caloduc à fentes ayant des fentes périphériques selon la revendication 7, dans lequel, si une partie de la gaine du système de caloduc à fentes de forme irrégulière est chauffée, le milieu de fonctionnement liquide dans les fentes axiales (8) au niveau de la partie absorbe la chaleur et d'évapore, et se transforme en vapeur à haute pression afin de pénétrer dans le passage de vapeur (11), et la vapeur à haute pression pénètre dans n'importe quelle autre partie du système de caloduc de forme irrégulière, excepté la partie chauffée à travers les passages de vapeur (11) en communication les uns avec les autres, et se condense en milieu de fonctionnement liquide au niveau de n'importe quelle autre partie, et le milieu de fonctionnement liquide revient ensuite vers la partie d'évaporation chauffée le long des fentes axiales (8) en communication les unes avec les autres, par un effet de force d'aspiration capillaire généré par la partie d'évaporation chauffée, et le processus entier est répété, et le transfert de chaleur et l'égalisation de température du système de caloduc de forme irrégulière sont réalisés par le biais de l'écoulement de milieu de fonctionnement et de la transition de phase vapeur-liquide.

10. Procédé d'assemblage de caloducs à fentes ayant des fentes périphériques selon l'une quelconque des revendications 1 à 9, comprenant les étapes suivantes :

   une étape 1, qui consiste à prévoir des gaines de caloducs à fentes axiales (9) à raccorder ; à prévoir des fentes périphériques (7) dans les gaines de conduits (9), et à prévoir une gaine de protection (1), une gaine de conduit principal (3) et une gaine de conduit de dérivation (2) d'un joint d'égalisation de température ;
   une étape 2, qui consiste à prévoir un embout d'étanchéité (14), un embout de remplissage (13) et un conduit de remplissage (12) ;
   une étape 3, qui consiste à assembler les gaines de caloducs à fentes axiales (9) à raccorder, la gaine de protection (1), la gaine de conduit principal (3) et la gaine de conduit de dérivation (2) du joint d'égalisation de température tous prévus à l'étape 1, avec le conduit de remplissage (12), l'embout d'étanchéité (14) et l'embout de remplissage (13) tous prévus à l'étape 2, afin de former et de fermer un caloduc à fentes ayant des fentes périphériques.

11. Procédé d'assemblage de caloducs à fentes ayant des fentes périphériques selon la revendication 10, dans lequel l'étape 1 qui consiste à prévoir des gaines de caloducs à fentes axiales à raccorder ; à prévoir des fentes périphériques dans les gaines de conduits (9), et à prévoir une gaine de protection, une gaine de conduit principal (3) et une gaine de conduit de dérivation (2) d'un joint d'égalisation de température comprend spécifiquement les étapes suivantes :

une étape 1.1, qui consiste à prévoir les gaines de caloducs à fentes axiales (9) à raccorder ; à désactiver les ailettes sur une certaine longueur à une extrémité de la gaine de caloduc à fentes axiales (9) à raccorder au joint d'égalisation de température afin de former une extrémité cylindrique avec une certaine longueur ; à prévoir une rainure avec une certaine longueur à l'intérieur d'une autre extrémité de la gaine de caloduc à fentes axiales (9) à ne pas raccorder au joint d'égalisation de température afin d'installer l'embout de remplissage (13) ou l'embout d'étanchéité (14) ;
une étape 1.2, sur la base de l'étape 1.1, qui consiste à prévoir au moins trois fentes périphériques espacées à l'extrémité de la gaine de caloduc à fentes axiales (9) à raccorder au joint d'égalisation de température, dans lequel le plan sur lequel les fentes périphériques se trouvent est orthogonal par rapport aux plans sur lesquels les fentes axiales se trouvent ;
une étape 1.3, qui consiste à prévoir la gaine de protection du joint d'égalisation de température, dans lequel un diamètre interne de la gaine de protection est identique à un diamètre externe de l'extrémité cylindrique du caloduc à fentes axiales prévue à l'étape 1 ; et
une étape 1.4, qui consiste à prévoir la gaine de conduit principal (3) et la gaine de conduit de dérivation (2) du joint d'égalisation de température ; dans lequel les diamètres externes de la gaine de conduit principal (3) et de la gaine de conduit de dérivation (2) sont identiques à un diamètre externe de la gaine de protection du joint d'égalisation de température, les dimensions de section axiale de la gaine de conduit principal (3) et de la gaine de conduit de dérivation (2) (comprenant le nombre de fentes axiales, la taille des fentes axiales et la taille des passages de vapeur) sont exactement les mêmes que les dimensions de section axiale de la gaine de conduit à fentes axiales (9).

12. Procédé d'assemblage de caloducs à fentes ayant des fentes périphériques selon la revendication 10, dans lequel l'étape 2 qui consiste à prévoir un embout d'étanchéité (14), un embout de remplissage (13) et un conduit de remplissage (12) comprend spécifiquement les étapes suivantes :

une étape 2.1, qui consiste à prévoir l'embout d'étanchéité (14), dans lequel l'embout d'étanchéité (14) possède une structure cylindrique, et un diamètre externe de l'embout d'étanchéité (14) est identique à un diamètre interne de la rainure prévue sur la gaine de caloduc à fentes axiales (9) ;
une étape 2.2, qui consiste à prévoir l'embout de remplissage (13), dans lequel l'embout de remplissage (13) possède une structure cylindrique, et un diamètre externe de l'embout de remplissage (13) est identique au diamètre interne de la rainure prévue sur la gaine de caloduc à fentes axiales (9) ; et à percer un orifice traversant au milieu de l'embout de remplissage (13) ; et
une étape 2.3, qui consiste à prévoir le conduit de remplissage (12), dans lequel un diamètre externe du conduit de remplissage (12) est identique à un diamètre de l'orifice traversant au milieu de l'embout de remplissage (13).

13. Procédé d'assemblage de caloducs à fentes ayant des fentes périphériques selon la revendication 10, dans lequel l'étape 3 qui consiste à assembler les gaines de caloducs à fentes axiales (9) à raccorder, la gaine de protection, la gaine de conduit principal (3) et la gaine de conduit de dérivation (2) du joint d'égalisation de température tous prévus à l'étape 1, avec le conduit de remplissage (12), l'embout d'étanchéité (14) et l'embout de remplissage (13) tous prévus à l'étape 2, et à procéder à la fermeture, comprend spécifiquement les étapes suivantes :

une étape 3.1, qui consiste à placer la gaine de conduit principal (3) avec une rainure en forme de V dans la gaine de protection du joint d'égalisation de température, puis à placer la gaine de conduit de dérivation (2) avec une saillie en forme de V dans la gaine de protection du joint d'égalisation de température, dans lequel la saillie en forme de V de la gaine de conduit de dérivation (2) est insérée dans la rainure en forme de V de la gaine de conduit principal (3) ;
une étape 3.2, qui consiste à placer des treillis métalliques (10) dans la gaine de conduit principal (3) et la gaine de conduit de dérivation (2), et à faire buter les treillis métalliques (10) contre les parois internes de la gaine de conduit principal (3) et de la gaine de conduit de dérivation (2) ;

une étape 3.3, qui consiste à insérer les extrémités cylindriques prévues des gaines de caloducs à fentes axiales (9) dans la gaine de protection du joint d'égalisation de température, et à faire buter les extrémités cylindriques avec les extrémités de la gaine de conduit principal (3) et de la gaine de conduit de dérivation (2) ; à s'assurer que les fentes axiales de la gaine de caloduc à fentes axiales (9) sont en correspondance biunivoque avec les fentes axiales de la gaine de conduit principal (3) et la gaine de conduit de dérivation (2), tout comme les passages de vapeur, et à s'assurer qu'une partie des treillis métalliques (10) dans la gaine de conduit principal (3) et la gaine de conduit de dérivation (2) se trouve dans les caloducs à fentes axiales et bute contre les parois internes des caloducs à fentes axiales ;

une étape 3.4, qui consiste à souder et fixer les gaines de caloducs à fentes axiales (9) sur le joint d'égalisation de température et à les fermer les unes contre les autres, dans un état dans lequel les gaines de caloducs à fentes axiales (9) se trouvent au bout du joint d'égalisation de température ;

une étape 3.5, qui consiste à placer l'embout de remplissage (13) dans la rainure à l'extrémité libre des caloducs à fentes axiales, et à fixer l'embout de remplissage (13) sur la rainure en les soudant et en les fermant l'un contre l'autre ;

une étape 3.6, qui consiste à insérer le conduit de remplissage (12) dans l'orifice traversant de l'embout de remplissage (13), et à fixer le conduit de remplissage (12) sur l'orifice traversant en les soudant et en les fermant l'un contre l'autre ; et

une étape 3.7, qui consiste à placer l'embout d'étanchéité (14) dans la rainure à l'autre extrémité libre des gaines de caloducs à fentes axiales (9), et à fixer l'embout d'étanchéité (14) sur la rainure en les soudant et en les fermant l'un contre l'autre ; et, après cette étape, l'assemblage est terminé.

**FIG. 1**

**FIG. 2**

**FIG. 3**

**FIG. 4**

**FIG. 5**

Full pre-embedded type      Hybrid type      Full external-pasted type

equalizer heat pipe

parallel heat pipe

equalizer heat pipe

parallel heat pipe

parallel heat pipe    equalizer heat pipe

**FIG. 6**

T-shaped vertical pipe

T-shaped horizontal pipe

**FIG. 7**

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 101893398 A
- CN 106482561 A
- CN 201885615 U

- CN 109041540 A
- US 2018187979 A1